(19) Europäisches Patentamt
European Patent Office
Office européen des brevets

(11) EP 3 041 028 A1

(12) EUROPEAN PATENT APPLICATION
published in accordance with Art. 153(4) EPC

(43) Date of publication:
**06.07.2016 Bulletin 2016/27**

(21) Application number: **14838940.6**

(22) Date of filing: **27.08.2014**

(51) Int Cl.:
***H01L 21/02*** *(2006.01)* ***B24B 37/30*** *(2012.01)*
***B32B 27/00*** *(2006.01)* ***B32B 27/30*** *(2006.01)*
***H01L 21/304*** *(2006.01)*

(86) International application number:
**PCT/JP2014/072370**

(87) International publication number:
**WO 2015/030032 (05.03.2015 Gazette 2015/09)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **30.08.2013 JP 2013180043**
**27.03.2014 JP 2014066385**

(71) Applicant: **Fujifilm Corporation**
**Minato-ku**
**Tokyo 106-8620 (JP)**

(72) Inventors:
- **KOYAMA Ichiro**
  **Haibara-gun**
  **Shizuoka 421-0396 (JP)**
- **IWAI Yu**
  **Haibara-gun**
  **Shizuoka 421-0396 (JP)**
- **KAMOCHI Yoshitaka**
  **Haibara-gun**
  **Shizuoka 421-0396 (JP)**

(74) Representative: **Hoffmann Eitle**
**Patent- und Rechtsanwälte PartmbB**
**Arabellastraße 30**
**81925 München (DE)**

# (54) LAMINATE AND APPLICATION THEREOF

(57) Provided are a temporary bonding layer laminate for producing a semiconductor device, which can reliably and easily provide a temporary support for the device wafer when the device wafer is subjected to a mechanical or chemical treatment and can easily provide a release from the temporary support for the device wafer while not damaging the device wafer even after undergoing a process at a high temperature; and a composition for forming a protective layer, a composition for forming a release layer, and a kit, each of which is used for the production of the laminate.

The laminate has a device wafer, a protective layer, a release layer, and a support substrate in this order, in which the protective layer is in contact only with the device wafer and the release layer, the release layer is in contact only with the protective layer and the support substrate, and the release layer contains a fluorine atom and/or a silicon atom.

FIG. 1A

FIG. 1B

FIG. 1C

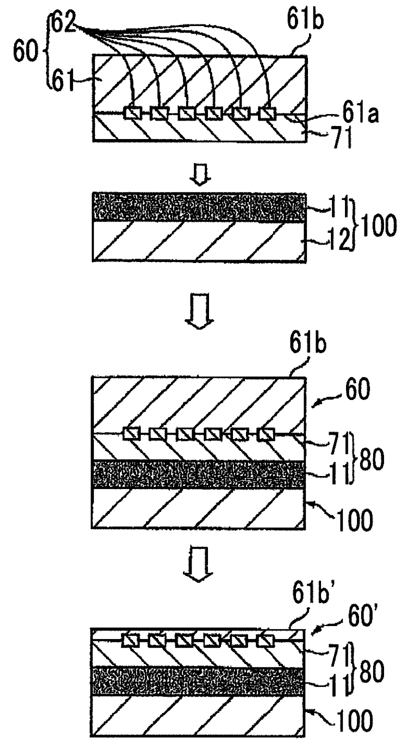


EP 3 041 028 A1

## Description

## BACKGROUND OF THE INVENTION

1. Field of the Invention

The present invention relates to a laminate, a composition for forming a protective layer, a composition for forming a release layer, and a kit. More specifically, the present invention relates to a laminate temporarily bonded to an adhesive support using a temporary adhesive for producing a semiconductor device; a composition for forming a protective layer and a composition for forming a release layer, each of which is used in the laminate; and a kit including the composition for forming a protective layer and the composition for forming a release layer.

2. Description of the Related Art

Heretofore, in the production process of a semiconductor device such as an integrated circuit (IC) and a large-scale integrated circuit (LSI), usually, a large number of IC chips are formed on a semiconductor silicon wafer and diced by dicing.

With the needs for further miniaturization and higher performance of electronic devices, there is a demand for further miniaturization and higher integration of IC chips mounted on electronic devices, but the high integration of the integrated circuit in the plane direction of a silicon substrate is close to the limit.

As a method from an electrical connection of an integrated circuit in an IC chip to an external terminal of the IC chip, a wire bonding method has been heretofore widely known. In order to miniaturize the IC chip, in recent years, a method where a through hole is provided in a silicon substrate and a metal plug, as the external terminal is connected to the integrated circuit so as to pass through the through hole (a method for forming a so-called through-silicon electrode (TSV)) has become known. However, according to the method for forming a through silicon-electrode singly, the needs of higher integration for the IC chip in recent years as described above have not been sufficiently fulfilled.

In light of the above, a technique of improving the integration density per unit area of the silicon substrate by making the integrated circuit in an IC chip multi-layered is known. However, since a multi-layered integrated circuit increases the thickness of the IC chip, reduction in the thickness of members constituting the IC chip is required. As to the reduction in the thickness of the members, for example, reduction in the thickness of the silicon substrate has been studied and is promising not only to lead to the miniaturization of an IC chip but also to save labor in a through-hole producing step of the silicon substrate in the manufacture of the through-silicon electrode.

As a semiconductor silicon wafer which is used in a process for producing a semiconductor device, a semiconductor silicon wafer having a thickness from about 700 μm to about 900 μm is widely known. In recent years, for the purpose of miniaturization of an IC chip, it has been attempted to reduce the thickness of a semiconductor silicon wafer to 200 μm or less.

However, since a semiconductor silicon wafer having a thickness of 200 μm or less is very thin and thus, a member for producing a semiconductor device using this semiconductor silicon wafer as a base material is also very thin, and therefore, in the case, for example, where the member is subjected to an additional treatment or where the member is simply moved, it is difficult to support the member stably while not damaging the member.

In order to solve the problems as described above, a technique is known, in which a semiconductor wafer having a device provided on the surface thereof before reducing the thickness, a support substrate for a processing is temporarily adhered to a support substance for processing with a silicone adhesive, a back surface of the semiconductor wafer is ground to make it thin, the semiconductor wafer is punched to provide a through-silicon electrode, and then the support substrate for a processing is dissociated from the semiconductor wafer (see JP2011-119427A). It is described that this technique, resistance to grinding during grinding of the back surface of the semiconductor wafer, heat resistance in an anisotropic dry etching step or the like, chemical resistance during plating and etching, smooth final peeling from the support substrate for processing and a low adherend contamination property are able to be achieved at the same time.

Furthermore, as a method of supporting a wafer, a technique for supporting a wafer by a support layer system, in which between the wafer and the support layer system, a plasma polymer layer obtained by a plasma deposition method is interposed as a separation layer, and an adhesive bond between the support layer system and the separation layer is made greater than an adhesive bond between the wafer and the separation layer such that the wafer can be easily released from the separation layer when the wafer is dissociated from the support layer system is also known(see JP2009-528688A).

Furthermore, a technique for performing temporary adhesion using a polyethersulfone and a viscosity imparting agent, and then releasing the temporary adhesion with heating is known (JP2011-225814A).

Incidentally, a technique for performing temporary adhesion with a mixture formed of carboxylic acids and amines, and then releasing the temporary adhesion with heating is known (JP2011-052142A).

In addition, a technique is known, in which a device wafer and a support substrate are bonded with pressure to be adhered in a state where an adhesion layer formed of cellulose polymers and the like is heated, and then the device wafer is dissociated from the support substrate by laterally sliding under heating (JP2010-506406A).

Moreover, an adhesion film formed of syndiotactic 1,2-polybutadiene and a photopolymerization initiator, an adhesive force of which is changed by irradiation with radiation is known (JP2007-045939A).

Further, a technique is known, in which a support substrate and a semiconductor wafer are temporarily adhered to each other with an adhesive formed of polycarbonates, the semiconductor wafer is subjected to a treatment and then to irradiation of radiation and then heating to dissociate the treated semiconductor wafer from the support substrate (US2011/0318938A).

Furthermore, a technique is known, in which when a device surface provided with a micro-device of a device wafer is temporarily adhered to a carrier substrate that supports the device wafer, a filling layer that does not contribute to the bonding is interposed between the central region of the device surface and the carrier substrate to provide a temporary adhesion between the peripheral portion of the device surface and the carrier substrate by an adhesive is known (JP2011-510518A).

## SUMMARY OF THE INVENTION

Meanwhile, in the case where a surface of a semiconductor wafer provided with a device (that is, a device surface of a device wafer) is temporarily adhered to a support substrate (that is, a carrier substrate) through a layer formed of the adhesive known in JP2009-528688A or the like, a certain level of adhesive strength is required for the adhesive layer in order to stably support the semiconductor wafer.

Therefore, in the case where the whole device surface of the semiconductor wafer and the support substrate are temporarily adhered to each other through the adhesive layer, when the temporary adhesion between the semiconductor wafer and the support substrate is made sufficient in order to support the semiconductor wafer stably and while not damaging the semiconductor wafer, due to too strong temporary adhesion between the semiconductor wafer and the support substrate, on the other hand, a problem in that the device is damaged or in that the device is dissociated from the semiconductor wafer is likely to occur, when the semiconductor wafer is dissociated from the support substrate.

Furthermore, the method of forming as a separation layer, a plasma polymer layer by a plasma deposition method between the wafer and the support layer system as in JP2009-528688A in order to prevent the adhesion between the wafer and the support layer system becoming too strong has problems (1) in that the equipment cost for performing the plasma deposition method is ordinarily high; (2) in that the layer formation by the plasma deposition method requires time for vacuumization in the plasma apparatus and deposition of monomers; (3) in that even when the separation layer formed of a plasma polymer layer is provided, it is not easy to control the adhesive bond in such a manner that the wafer is easily dissociated from the separation layer in the case of releasing the supporting of the wafer, while, on the other hand, the adhesive bond between the wafer and the separation layer is sufficiently maintained in the case of supporting the wafer subjected to the processing; and in others.

Moreover, in a method of releasing the temporary adhesion with heating as described in JP2011-225814A, JP2011-052142A, and JP2010-506406A, a problem in that the device is damaged by heating for a long period of time is likely to occur.

Furthermore, in a method of releasing the temporary adhesion by irradiation with radiation as described in JP2007-045939A and US2011/0318938A, it is necessary to use a support substrate into which the radiation penetrates.

In addition, in a method for interposing a filling layer that does not contribute to the adhesion onto a carrier as in JP2011-510518A, it is necessary to carry out a process including multiple steps when forming the filling layer, and thus, there is room for further improvement in productivity.

Under these circumstances, the present invention has been realized, and it is an object of the present invention to provide a laminate which can reliably and easily provide a temporary support onto a device wafer when the device wafer is subjected to a mechanical or chemical treatment, and can easily provide a release from the temporary support for the device wafer while not damaging the device wafer even in the case of undergoing a process at a high temperature; a composition for forming a protective layer and a composition for forming a release layer, each of which is used in the laminate; and a kit including the composition for forming a protective layer and the composition for forming a release layer.

The present inventors have conducted extensive studies to accomplish the above-described object, and as a result, they have found that by laminating a device wafer, a protective layer, a release layer, and a support in this order, bringing the protective layer into contact only with the device wafer and the release layer, and bringing the release layer into contact only with the protective layer and the support, and incorporating any one of fluorine atoms and silicon atoms into the release layer, it is possible to easily release the temporary support from the device wafer which has been subjected to a treatment even in a case of undergoing a process at a high temperature. Based on these findings, they could complete the present invention.

Specifically, the above object was accomplished by the following means <1>, and more preferably by <2> to

<20>.

<1> A laminate including a device wafer, a protective layer, a release layer, and a support substrate in this order, in which the protective layer is in contact only with the device wafer and the release layer, the release layer is in contact only with the protective layer and the support substrate, and the release layer contains a fluorine atom and/or a silicon atom.

<2> The laminate as described in <1>, in which the release layer includes a three-dimensional crosslinked product containing a fluorine atom and/or a silicon atom.

<3> The laminate as described in <1>, in which the release layer includes a three-dimensional crosslinked product and 50% by mass or more of the three-dimensional crosslinked product is constituted with fluorine atoms.

<4> The laminate as described in any one of <1> to <3>, in which the release layer includes at least one of a radical polymerization product of a bifunctional or higher functional radically polymerizable monomer or oligomer containing a fluorine atom and a condensate of an alkoxysilane compound containing a fluorine atom.

<5> The laminate as described in any one of <1> to <4>, in which the protective layer includes a thermoplastic resin.

<6> The laminate as described in <5>, in which the thermoplastic resin includes at least one of a polycarbonate resin, a polystyrene resin, and a polystyrene copolymerized resin.

<7> The laminate as described in any one of <1> to <6>, in which the softening point of the protective layer is 200°C or lower.

<8> The laminate as described in any one of <1> to <7>, in which the protective layer further includes a plasticizer.

<9> The laminate as described in any one of <1> to <8>, in which the protective layer further includes an antioxidant.

<10> The laminate as described in any one of <1> to <9>, in which at least one of the release layer and the protective layer further includes a polymer compound containing a fluorine atom with a non-three-dimensional crosslinked structure.

<11> The laminate as described in any one of <1> to <10>, in which the average thickness of the device wafer is 500 $\mu$m or more.

<12> The laminate as described in any one of <1> to <10>, in which the average thickness of the device wafer is less than 500 $\mu$m.

<13> The laminate as described in any one of <1> to <12>, in which the device wafer has a structure having a height of 5 $\mu$m to 100 $\mu$m and the average thickness of the protective layer is more than the height of the structure.

<14> A composition for forming a protective layer, used for forming the protective layer of the laminate as described in any one of <1> to <13>, including a solvent and a resin.

<15> The composition for forming a protective layer as described in <14>, in which the resin includes a thermoplastic resin.

<16> The composition for forming a protective layer as described in <15>, in which the thermoplastic resin includes at least one of a polycarbonate, a polystyrene resin, and a polystyrene-copolymerized resin.

<17> The composition for forming a protective layer as described in any one of <14> to <16>, in which the softening point of the resin is 200°C or lower.

<18> A composition for forming a release layer, used for forming the release layer of the laminate as described in any one of <1> to <13>, which includes a material containing a fluorine atom and/or a silicon atom, and a solvent.

<19> The composition for forming a release layer as described in <18>, in which the material containing a fluorine atom and/or a silicon atom includes at least one of a bifunctional or higher functional radically polymerizable monomer or oligomer containing a fluorine atom, and an alkoxysilane compound containing a fluorine atom.

<20> A kit for forming the laminate as described in any one of <1> to <13>, including a composition for forming a protective layer including a solvent and a resin, and a composition for forming a release layer, including a material containing a fluorine atom and/or a silicon atom and a solvent.

According to the present invention, it is possible to provide a laminate which can reliably and easily provide a reliable temporary support onto a device wafer when the device wafer is subjected to a mechanical or chemical treatment, and can easily provide a release from the temporary support for the device wafer while not damaging the device wafer even in the case of undergoing a process at a high temperature; a composition for forming a release layer; and a kit including the composition for forming a protective layer and the composition for forming a release layer.

## BRIEF DESCRIPTION OF THE DRAWINGS

In Figs. 1A, 1B, and 1C in Fig. 1 are a schematic cross-sectional view showing the temporary adhesion between an adhesive support and a device wafer, a schematic cross-sectional view showing a device wafer temporarily adhered by an adhesive support, and a schematic cross-sectional view showing a state in which the device wafer temporarily adhered by an adhesive support becomes thinner, respectively.

Fig. 2 is a schematic cross-sectional view illustrating a release of the temporary adhesion state between an adhesive support and a device wafer in the related art.

## DESCRIPTION OF THE PREFERRED EMBODIMENTS

Hereinafter, embodiments of the present invention will be described in detail. In citations for a group (atomic group) in the present specification, when the group is denoted without specifying whether it is substituted or unsubstituted, the group includes both a group having no substituent and a group having a substituent. For example, an "alkyl group" includes not only an alkyl group having no substituent (unsubstituted alkyl group), but also an alkyl group having a substituent (substituted alkyl group).

"Actinic ray" or "radiation" in the present specification means, for example, visible light, ultraviolet rays, far ultraviolet rays, electron beams, X-rays, or the like. In addition, in the present invention, "light" means actinic rays or radiation.

Furthermore, "exposure" in the present specification includes, unless otherwise specified, not only exposure by a mercury lamp, ultraviolet rays, far ultraviolet rays represented by an excimer laser, X-rays, EUV rays, or the like, but also writing by particle rays such as electron beams and ion beams.

In addition, in the present specification, "(meth)acrylate" represents either or both of acrylate and methacrylate, "(meth)acryl" represents either or both of acryl and methacryl, and "(meth)acryloyl" represents either or both of acryloyl and methacryloyl. Further, in the present specification, a "monomer material" and a "monomer" have the same definition. The monomer in the present invention is distinguished from an oligomer and a polymer, and refers to a compound having a mass average molecular weight of 2,000 or less. In the present specification, the polymerizable compound refers to a compound containing a polymerizable group, and may be either a monomer or a polymer. The polymerizable group refers to a group involved in the polymerization reaction. The polymer compound in the present invention refers to a compound having a mass average molecular weight of more than 2,000.

Furthermore, in the embodiments as described below, the member or the like described in the drawing already referred to is indicated by the same or corresponding symbol in the figure and its description is simplified or omitted.

Laminate:

The laminate of the present invention includes a device wafer, a protective layer, a release layer, and a support substrate in this order, in which the protective layer is in contact only with the device wafer and the release layer, the release layer is in contact only with the protective layer and the support substrate, and the release layer contains a fluorine atom and/or a silicon atom. That is, as shown in Fig. 1, the laminate is configured such that the protective layer 71 is in contact only with a device wafer 60 and a release layer 11, not in contact with other members, the release layer 11 is in contact only with a protective layer 71 and a support substrate 12, not in contact with other members. Here, the protective layer and the release layer may each be formed of either one layer or two layers. The protective layer and the release layer are preferably one layer.

Moreover, in Fig. 1, the device wafer 60, the protective layer 71, the release layer 13, and the support substrate 12 have substantially the same sizes of the projected areas when viewed from the film surface, but it is not necessary that they always have the same size. However, in the laminate of the present invention, the projected areas of the device wafer, the protective layer, and the release layer when viewed from the film surface of the laminate are each within the range of preferably $\pm 10\%$, and more preferably $\pm 5\%$ of the projected area of the support substrate.

Again back to Fig. 1, here, the device wafer 60 is formed of, for example, a silicon substrate 60 and a structure 62 provided on the surface thereof as will described later in detail, and all of these are collectively referred to as a device wafer in the present invention.

In the present invention, the protective layer is not in contact with the adhesive but only with the device wafer and the release layer, and the release layer is not in contact with the adhesive, but only with the protective layer and the support substrate, whereby the device wafer and the support substrate semiconductor are easily peeled after performing the processing. Further, by providing the protective layer, the support substrate is easily peeled while a device wafer having a structure of a bump or the like is appropriately protected.

Therefore, according to the laminate of the present invention, it is possible to reliably and easily provide a reliable temporary support onto a device wafer when the device wafer is subjected to a mechanic or chemical treatment, and easily provide a release of the temporary support for the treated device wafer while not damaging the device wafer even in the case of undergoing a process at a high temperature.

The laminate for manufacturing a laminate in the present invention is preferably for formation of through-silicon electrode. The formation of the through-silicon electrode will be described in detail later.

Hereinafter, the respective components which may be included in the laminate of the present invention will be described in detail.

<Protective Layer>

The protective layer is used for the purpose of protecting the surface of a surface which is not subjected to treatment of the device wafer.

The softening point of the protective layer is preferably lower than the upper limit, 250°C, of an ordinary bonding temperature of the device wafer and the support. This is due to a fact that the surface of the protective layer is easily planarized during the bonding. From this viewpoint, the softening point of the protective layer is preferably 250°C or lower, more preferably 220°C or lower, and particularly preferably 200°C or lower. With such a softening point, the protective layer is softened during the heating and the processing, and thus, the unevenness of the surface of the release layer and the release layer can be reduced even when the release layer becomes hard.

The softening point of the protective layer is measured as a temperature at which the loss tangent (tanδ) measured using an viscoelastiity measuring apparatus under a constant temperature rising condition becomes a maximum.

The loss tangent (tanδ) is calculated by the following equation.

$$\tan\delta = G''/G'$$

In the equation, G" represents a loss shear elastic modulus and G' represents a storage shear elastic modulus.

The temperature rising rate is preferably in the range of 0.5°C/min to 20°C/min, more preferably in the range of 1°C/min to 10°C/min, and particularly preferably in the range of 2°C/min to 5°C/min.

The method of forming the protective layer is not particularly limited, and it can be suitably accomplished by appropriately modifying the type and the content of the resin component (binder) as will be described below as a preferred one and is accomplished by selecting the binder from the preferred specific examples as will be described later and setting a more preferred concentration.

Specifically, the protective layer can be formed by applying a composition for forming a protective layer to a device wafer, using a spin coat method known in the related art, a spray method, a screen printing method, a roller coating method, a flow coating method, a doctor coating method, and an immersion method, and then drying it. Among these, a spin coating method, a spray method, and a screen printing method are preferable, a spin coating method and a spray method are more preferable, and a spin coating method is particularly preferable.

The average thickness of the protective layer is preferably 1 μm to 500 μm, more preferably 10 μm to 75 μm, and particularly preferably 15 μm to 60 μm. In particular, it is preferable that the average thickness of the protective layer is larger than the height of the structure of the device wafer as will be described later.

The storage elastic modulus of the protective layer at 25°C is preferably 1 M to 1 GPa, more preferably 10 M to 1 GPa, and still more preferably 100 M to 1 GPa. Bu setting the protective layer the release layer to the elastic modulus as will be described later, the unevenness occurring when polishing the device can be more effectively inhibited, and both of strong adhesiveness when the device wafer which will be described later becomes thinner and the release peelability when the device wafer is separated can be met more effectively.

As a material that constitutes the protective layer, known materials can be used without limitation, and those including resin components which will be described later are preferable.

«Resin Component»

In the present invention, as the resin component which can be included in the composition for forming a protective layer, an arbitrary one can be used.

Examples thereof include synthetic resins such as a terpene resin, a terpene phenol resin, a modified terpene resin, a hydrogenated terpene resin, a hydrogenated terpene phenol resin, a rosin, a rosin ester, a hydrogenated rosin, a hydrogenated rosin ester, a polymerized rosin, a polymerized rosin ester, a modified rosin, a rosin-modified phenol resin, an alkylphenol resin, an aliphatic petroleum resin, an aromatic petroleum resin, a hydrogenated petroleum resin, a modified petroleum resin, an alicyclic petroleum resin, a coumarone petroleum resin, an indene petroleum resin, an olefin copolymer (for example, a methylpentene copolymer), a cycloolefm copolymer (for example, a norbornene copolymer, a dicyclopentadiene copolymer, and a tetracyclododecene copolymer), a novolac resin, a phenol resin, an epoxy resin, a melamine resin, a urea resin, an unsaturated polyester resin, an alkyd resin, a polyurethane resin, a polyimide resin, a polyethylene resin, a polypropylene resin, an ethylene-propylene copolymemr (EPDM rubber), a polyvinyl chloride resin, a polystyrene resin, a polystyrene copolymerized resin (for example, an acrylonitrile-butadiene-styrene copolymer (ABS resin), an acrylonitrile-styrene copolymer (AS resin), and a methyl methacrylate-styrene copolymerized resin (MS resin)), a polyvinyl acetate resin, an ethylene tetrafluoride resin (PTFE resin), a tetrafluoroethylene/perfluoroalkoxyethylene copolymer (PFA resin), a tetrafluoroethylene/hexafluoropropylene copolymer (FEP resin), an ethylene/TFE copolymerized resin, polyvinylidene fluoride (PVDF resin), polychlorotrifluoroethylene (PCTFE resin), an ethylene/chlorotrifluoroethylene resin (CTFE resin), a TFE/perfluorodimethyldioxol copolymerized resin, a polyvinyl fluoride resin (PVF resin), an acrylic resin, a cellulose resin, a polyamide, a polyacetal, a polycarbonate, a polyphenylene ether, polybutylene terephthalate, polyethylene terephthalate, a cyclic polyolefin, a polyphenylene sulfide, a polysulfone, a polyether sulfone resin, a polybenzimidazole resin, a polyacrylate resin, a polyether ketone resin, and a polyamideimide resin, and natural resins such as natural rubber. Among these, a polystyrene resin, a polystyrene copolymerized resin, a polycarbonate resin, a polyether sulfone resin, a polyimide resin, a polyester resin, a polybenzimidazole resin, and a polyamideimide resin are preferable, a polystyrene resin, a polystyrene copolymerized resin, a polycarbonate resin, a polyether sulfone resin, a polyimide resin, a polyester resin, a polybenzimidazole resin, a polyamideimide resin, a polyether ketone resin are more preferable, and a polystyrene resin, a polystyrene copolymerized resin, and a polycarbonate resin are particularly preferable.

The resin component is preferably a thermoplastic resin, and particularly preferably at least one thermoplastic resin selected from a polycarbonate resin, a polystyrene resin, and a polystyrene copolymerized resin.

As a commercially available product thereof, APEC9379 (manufactured by BAYER Inc.), ESTYRENE MS200NT (manufactured by Nippon Steel Chemical Co., Ltd.), SEPTON S2002, SEPTON S2004, SEPTON S2007, SEPTON S2104, SEPTON S2063, and SEPTON S8104 (manufactured by Kuraray Co., Ltd.), TOPAS8007 (manufactured by Polyplastics Co., Ltd.), APEL8008 (manufactured by Mitsui Chemicals, Inc.), L-70 (manufactured by Daicel Chemical Industries, Ltd.), Ultrason E2020 (manufactured by BASF), Durimide 284 (manufactured by Fuji Photo Film Co., Ltd.), and TUFTEC P2000 and TUFTEC H1043 (manufactured by Asahi Kasei Chemicals Corp.), or the like can be suitably used.

The amount of the resin components added in the protective layer is preferably 1% by mass to 100% by mass, more preferably 70% by weight to 100% by weight, and particularly preferably 90% by weight to 100% by weight, with respect to the total solid content (amount excluding the solvent) of the protective layer.

One kind or two or more kinds of the resin component may be used. In the case where two or more kinds of the resin are used, the total sum thereof is preferably within the above range.

«Solvent»

In the case where a layer is formed by applying the composition for forming a protective layer, it is preferable to blend the solvent.

The solvent can be used without limitation as long as it can form the protective layer. Suitable examples of the organic solvent include esters such as ethyl acetate, n-butyl acetate, isobutyl acetate, amyl formate, isoamyl acetate, isobutyl acetate, butyl propionate, isopropyl butyrate, ethyl butyrate, butyl butyrate, methyl lactate, ethyl lactate, alkyl oxyacetate (for example, methyl oxyacetate, ethyl oxyacetate, and butyl oxyacetate (for example, methyl methoxyacetate, ethyl methoxyacetate, butyl methoxyacetate, methyl ethoxyacetate, and ethyl ethoxyacetate)), alkyl 3-oxypropionate esters (for example, methyl 3-oxypropionate and ethyl 3-oxypropionate (for example, methyl 3-methoxypropionate, ethyl 3-methoxypropionate, methyl 3-ethoxypropionate, and ethyl 3-ethoxypropionate)), alkyl 2-oxypropionate esters (for example, methyl 2-oxypropionate, ethyl 2-oxypropionate, and propyl 2-oxypropionate (for example, methyl 2-methoxypropionate, ethyl 2-methoxypropionate, propyl 2-methoxypropionate, methyl 2-ethoxypropionate, and ethyl 2-ethoxypropionate)), methyl 2-oxy-2-methyl propionate and ethyl 2-oxy-2-methyl propionate (for example, methyl 2-methoxy-2-methyl propionate and ethyl 2-ethoxy-2-methyl propionate), methyl pyruvate, ethyl pyruvate, propyl pyruvate, methyl acetoacetate, ethyl acetoacetate, methyl 2-oxobutanoate, ethyl 2-oxobutanoate, decaline, and 1-methoxy-2-propylacetate (PGMEA); ethers such as diethylene glycol dimethyl ether, tetrahydrofuran, ethylene glycol monomethyl ether, ethylene glycol monoethyl ether, methyl cellosolve acetate, ethyl cellosolve acetate, diethylene glycol monomethyl ether, diethylene glycol monoethyl ether, diethylene glycol monobutyl ether, propylene glycol monomethyl ether, propylene glycol monomethy ether acetate, propylene glycol monoethyl ether acetate, and propylene glycol monopropyl ether acetate; ketones such as methyl amyl ketone, methyl ethyl ketone, 2-butanone, cyclohexanone, 2-heptanone, 3-heptanone, and N-methyl-2-pyrrolidone; and aromatic hydrocarbons such as toluene, xylene, anisole, mesitylene, and Limonene, and N,N-dimethylacetamide.

Among these, anisole, N-methyl-2-pyrrolidone, N,N-dimethylacetamide, 2-butanone, methyl amyl ketone, Limonene, mesitylene, methylethylketone, 1-methoxy-2-propylacetate (PGMEA), and the like can be used, and among these, anisole, N-methyl-2-pyrrolidone, N,N-dimethylacetamide, 2-butanone, methyl amyl ketone, Limonene, mesitylene, methylethylketone, 1-methoxy-2-propylacetate (PGMEA), and the like can be used, with N-methyl-2-pyrrolidone, N,N-dimethylacetamide, methyl amyl ketone, or Limonene being preferable.

From the viewpoints of improvement of the state of the coating surface, and the like, a form of mixing two or more kinds of the solvents is also preferable.

In the case where the composition for forming a protective layer has a solvent, the solvent is preferably used

such that the solid concentration of the composition for forming a protective layer is 5% by mass to 60% by mass.

One kind or two or more kinds of the solvent may be used. In the case where two or more kinds of the solvent are used, the total sum thereof is preferably within the above range.

«Surfactant»

From the viewpoint of further improving coatability, various surfactants may be added to the composition for forming a protective layer. As the surfactants, various surfactants such as a fluorine-based surfactant, a nonionic surfactant, a cationic surfactant, an anionic surfactant, and a silicone-based surfactant can be used.

In particular, by incorporating a fluorine-based surfactant into the protective layer included in the composition for forming a protective layer of the present invention, the liquid characteristics (particularly fluidity) of a coating liquid as prepared is further improved, so that the uniformity in the coating thickness or the liquid-saving properties can be further improved.

That is, in the case of forming a film by using a coating liquid obtained by applying the composition for forming a protective layer containing a fluorine-based surfactant, the interface tension between a surface to be coated and the coating liquid is reduced, whereby wettability to the surface to be coated is improved and the coatability on the surface to be coated is enhanced. This is effective in that even when a thin film of about several μm is formed with a small liquid volume, formation of a film with little thickness unevenness and uniform thickness can be carried out in a more suitable manner.

The fluorine content in the fluorine-based surfactant is preferably 3% by mass to 40% by mass, more preferably 5% by mass to 30% by mass, and particularly preferably 7% by mass to 25% by mass. The fluorine-based surfactant in which the fluorine content is within this range is effective in terms of the uniformity of the thickness of the coating film or liquid saving properties, and also exhibits good solubility of the surfactant in the composition for forming a protective layer.

Examples of the fluorine-based surfactant include Megaface F171, Megaface F172, Megaface F173, Megaface F176, Megaface F177, Megaface F141, Megaface F142, Megaface F143, Megaface F144, Megaface R30, Megaface F437, Megaface F475, Megaface F479, Megaface F482, Megaface F554, Megaface F780, and Megaface F781 (all manufactured by DIC Corporation), Florad FC430, Florad FC431, and Florad FC171 (all manufactured by Sumitomo 3M Ltd.), Surflon S-382, Surflon SC-101, Surflon SC-103, Surflon SC-104, Surflon SC-105, Surflon SC1068, Surflon SC-381, Surflon SC-383, Surflon S393, and Surflon KH-40 (all manufactured by Asahi Glass Co., Ltd.), and PF636, PF656, PF6320, PF6520, and PF7002 (all manufactured by OMNOVA Solutions Inc.).

Specific examples of the nonionic surfactant include glycerol, trimethylolpropane, trimethylolethane, and ethoxylate and propoxylate thereof (for example, glycerol propoxylate and glycerin ethoxylate), polyoxyethylene lauryl ether, polyoxyethylene stearyl ether, polyoxyethylene oleyl ether, polyoxyethylene octyl phenyl ether, polyoxyethylene nonyl phenyl ether, polyethylene glycol dilaurate, polyethylene glycol distearate, sorbitan fatty acid esters (Pluronic L10, L31, L61, L62, 10RS, 17R2, 25R2, and Tetronic 304, 701, 704, 901, 904, and 150R1 manufactured by BASF), and Solseperse 20,000 (manufactured by Lubrizol Japan Ltd.).

Specific examples of the cationic surfactant include phthalocyanine derivatives (product name: EFKA-745 manufactured by MORISHITA SANGYO Corporation), organosiloxane polymer KP341 (manufactured by Shin-Etsu Chemical Co., Ltd.), (meth)acrylic acid-based (co)polymer Polyflow No. 75, No. 90, and No. 95 (manufactured by KYOEISHA CHEMICAL CO., LTD.), and W001 (manufactured by Yusho Co., Ltd.).

Specific examples of the anionic surfactant include W004, W005, and W017 (manufactured by Yusho Co., Ltd.).

Examples of the silicone-based surfactant include "Toray Silicone DC3PA", "Toray Silicone SH7PA", "Toray Silicone DC11PA", "Toray Silicone SH21PA", "Toray Silicone SH28PA", "Toray Silicone SH29PA", "Toray Silicone SH30PA", and "Toray Silicone SH8400", manufactured by Dow Coming Toray, "TSF-4440", "TSF-4300", "TSF-4445", "TSF-4460", and "TSF-4452", manufactured by Momentive Performance Materials Inc., "KP341", "KF6001", and "KF6002", manufactured by Shin-Etsu Silicones, and "BYK307", "BYK323", and "BYK330", manufactured by BYK-Chemie.

In the case where the composition for forming a protective layer contains a surfactant, the amount of the surfactant added is preferably 0.001% by mass to 2.0% by mass and more preferably 0.005% by mass to 1.0% by mass, with respect to the total mass of the composition for forming a protective layer.

One kind or two or more kinds of surfactant may be used. In the case where the composition includes two or more kinds of the surfactant, the total amount thereof is preferably within the above range.

«Antioxidant»

A variety of antioxidants may also be added to the composition for forming a protective layer of the present invention from the viewpoint of preventing reduction in molecular weights and gelation of the protective layer resin due

to the oxidation during heating. As the antioxidant, a phenol-based antioxidant, a sulfur-based antioxidant, a quinone-based antioxidant, a nitrogen-based antioxidant, or the like can be used.

Examples of the phenol-based antioxidant include p-methoxyphenol, 2,6-di-tert-butyl-4-methylphenol, "Irganox 1010", "Irganox 1330", "Irganox 3114", and "Irganox 1035", manufactured by BASF, and "Sumilizer MDP-S" and "Sumilizer GA-80", manufactured by Sumitomo Chemical Co., Ltd.

Examples of the sulfur-based antioxidant include distearyl 3,3'-thiodipropionate, and "Sumilizer TPM", "Sumilizer TPS", and "Sumilizer TP-D", manufactured by Sumitomo Chemical Co., Ltd.

Examples of the quinone-based antioxidant include p-benzoquinone and 2-tert-butyl-1,4-benzoquinone.

Examples of the amine-based antioxidant include dimethylaniline and phenothiazine.

Among the antioxidants, Irganox 1010, Irganox 1330, distearyl 3,3'-thiodipropionate, and Sumilizer TP-D are preferable, Irganox 1010 and Irganox 1330 are more preferable, and Irganox1010 is particularly preferable.

Moreover, among the antioxidants, it is more preferable to use a combination of a phenol-based antioxidant and a sulfur-based antioxidant. As the combination of antioxidants, Irganox 1010 and Sumilizer TP-D, Irganox 1330 and Sumilizer TP-D, and Sumilizer GA-80 and Sumilizer TP-D are preferable, Irganox 1010 and Sumilizer TP-D, and Irganox 1330 and Sumilizer TP-D are more preferable, and Irganox 1010 and Sumilizer TP-D are particularly preferable.

From the viewpoint of preventing the sublimation during heating, the molecular weight of the antioxidant is preferably 400 or more, more preferably 600 or more, and particularly preferably 750 or more.

If the composition for forming a protective layer has an antioxidant, the amount of the antioxidant added is preferably 0.001% by mass to 20.0% by mass, and more preferably 0.005% by mass to 10.0% by mass, with respect to the total solid content of the composition for forming a protective layer.

One kind or two or more kinds of the antioxidant may be used. In the case where two or more kinds of the antioxidants are used, the total sum thereof is preferably within the above range.

«Plasticizer»

The composition for forming a protective layer of the present invention preferably includes a plasticizer in order to improve the deformation resistance at a high temperature and the adhesion flatness.

As the plasticizer, a phthalic acid ester, a fatty acid ester, an aromatic polyvalent carboxylic acid ester, a polyester, or the like can be used.

Examples of the phthalic acid esters include DMP, DEP, DBP, #10, BBP, DOP, DINP, and DIDP (all manufactured by Daihachi Chemical), PL-200 and DOIP (all manufactured by CG ESTER CORPORATION), and Sansocizer DUP (manufactured by New Japan Chemical Co., Ltd.)

Examples of the fatty acid ester include butyl stearate, UNISTAR M-9676, UNISTAR M-2222SL, UNISTAR H-476, UNISTAR H-476D, Panasate 800B, Panasate 875, and Panasate 810 (all manufactured by NOF), and DBA, DIBA, DBS, DOA, DINA, DIDA, DOS, BXA, DOZ, and DESU (all manufactured by Daihachi Chemical Industry Co., Ltd.).

Examples of the aromatic polycarboxylic acid ester include TOTM (manufactured by Daihachi Chemical Industry Co., Ltd.), Monocizer and W-705 (manufactured by Daihachi Chemical Industry Co., Ltd.), and UL-80 and UL-100 (manufactured by ADEKA). Examples of the polyester include POLYCIZER TD-1720, POLYCIZER S-2002, and POLYCIZER S-2010 (all manufactured by DIC), and BAA-15 (manufactured by Daihachi Chemical Industry Co., Ltd.).

Among the above plasticizers, DIDP, DIDA, TOTM, UNISTAR M-2222SL, and POLYCIZER TD-1720 are preferable, DIDA and TOTM are more preferable, and TOTM is particularly preferable. The plasticizers may be used singly or in combination of two or more kinds thereof.

From the viewpoint of preventing the sublimation during heating, with respect to the molecular weight of the plasticizer, the temperature at which the weight is decreased 1% by mass as measured under the conditions of a constant temperature rising rate of 20°C/minute is preferably 250°C or higher, more preferably 270°C or higher, and particularly preferably 300°C or higher. The upper limit is not particularly limited, and it can be set at, for example, 500°C or lower.

In the case where the composition for forming a protective layer in the present invention has a plasticizer, the amount of the plasticizer added is preferably 1% by mass to 50.0% by mass, and more preferably 5% by mass to 20% by mass, with respect to the total solid content of the composition for forming a protective layer.

<Polymer Compound Containing Fluorine Atom with Non-Three-Dimensional Crosslinked Structure>

It is preferable that the protective layer of the present invention includes a polymer compound containing a fluorine atom with a non-three-dimensional crosslinked structure. The non-three-dimensional crosslinked structure refers to a structure which does not include a crosslinked structure in a compound or the ratio of the crosslinked structures that forms a three-dimensional crosslinked structure to all the crosslinked structures in the compound is 5% or less, and preferably 1% or less. It is preferable that the crosslinked structures that forms a three-dimensional crosslinked structure are substantially included.

As the polymer compound containing a fluorine atom with a non-three-dimensional crosslinked structure, a polymer formed of one kind or two or more kinds of fluorine-containing monofunctional monomer can be preferably used. More specific examples thereof include at least one of fluorine-containing resin selected from a homopolymer of one kind or two or more kinds of fluorine-containing monofunctional monomer selected from tetrafluoroethylene, hexafluoropropane, tetrafluoroethylene oxide, hexafluoropropane oxide, perfluoroalkylvinyl ether, chlorotrifluoroethylene, vinylidene fluoride, and a perfluoroalkyl group-containing (meth)acrylic ester, or a copolymer of these monomers; a copolymer of one kind or two or more kinds of the fluorine-containing monofunctional monomer with ethylene; and a copolymer of one kind or two or more kinds of the fluorine-containing monofunctional monomer with chlorotrifluoroethylene.

As the polymer compound containing a fluorine atom with a non-three-dimensional crosslinked structure, a perfluoroalkyl group-containing (meth)acrylic resin which can be synthesized from a perfluoroalkyl group-containing (meth)acrylate ester is preferable.

As the perfluoroalkyl group-containing (meth)acrylate ester, specifically, a compound represented by the following Formula (101) is preferable.

Formula (101)

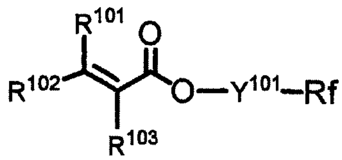

In General Formula (101), $R^{101}$, $R^{102}$, and $R^{103}$ each independently represent a hydrogen atom, an alkyl group, or a halogen atom. $Y^{101}$ represents a single bond or a divalent linking group selected from the group consisting of -CO-, -O-, -NH-, a divalent aliphatic group, a divalent aromatic group, and a combination thereof. Rf is a fluorine atom or an monovalent organic group containing at least one fluorine atom.

In General Formula (101), a preferred example of the alkyl group represented by $R^{101}$, $R^{102}$, and $R^{103}$ is an alkyl group having 1 to 8 carbon atoms, and examples thereof include a methyl group, an ethyl group, a propyl group, an octyl group, an isopropyl group, a tert-butyl group, an isopentyl group, a 2-ethylhexyl group, a 2-methylhexyl group, and a cyclopentyl group. A preferred example of the aryl group is an aryl having 6 to 12 carbon atoms, and examples thereof include a phenyl group, a 1-naphthyl group, and a 2-naphthyl group. Among them, as $R1^{01}$ to $R^{103}$, a hydrogen atom or a methyl group is preferable.

$Y^{101}$ represents a single bond or a divalent linking group selected from the group consisting of -CO-, -O-, -NH-, a divalent aliphatic group, a divalent aromatic group, and a combination thereof, and as the divalent aliphatic group, a chained structure is preferred to a cyclic structure, and a linear structure is preferred to a chained structure having a branch. The number of carbon atoms contained in the divalent aliphatic group is preferably 1 to 20, more preferably 1 to 15, still more preferably 1 to 12, even still more preferably 1 to 10, even still more preferably 1 to 8, and particularly preferably 1 to 4. Examples of the divalent aromatic group include a phenylene group, a substituted phenylene group, a naphthalene group, and a substituted naphthalene group, with the phenylene group being preferable.

As $Y^{101}$, an aliphatic group having a divalent linear structure is preferable.

The monovalent organic group containing a fluorine atom, represented by Rf, is not particularly limited, and is preferably a fluorine-containing alkyl group having 1 to 30 carbon atoms, more preferably a fluorine-containing alkyl group having 1 to 20 carbon atoms, and particularly preferably a fluorine-containing alkyl group having 1 to 15 carbon atoms. This fluorine-containing alkyl group may be linear {for example, $-CF_2CF_3$, $-CH_2(CF_2)_4H$, $-CH_2(CF_2)_8CF_3$, and $-CH_2CH_2(CF_2)_4H$}, may have a branched structure {for example, $-CH(CF_3)_2$, $-CH_2CF(CF_3)_2$, $-CH(CH_3)CF_2CF_3$, and $-CH(CH_3)(CF_2)_5CF_2H$), may have an alicyclic structure (preferably a 5- or 6-membered ring, for example, a perfluorocyclohexyl group, a perfluorocyclopentyl group, and an alkyl group substituted therewith), and may have an ether bond (for example, $-CH_2OCH_2CF_2CF_3$, $-CH_2CH_2OCH_2C_4F_8H$, $-CH_2CH_2OCH_2CH_2C_8F_{17}$, and $-CH_2CF_2OCF_2CF_2OCF_2CF_2H$). Further, it may be a perfluoroalkyl group.

That is, specifically, the perfluoroalkyl group-containing (meth)acrylic resin has a repeating unit represented by the following Formula (102).

Formula (102)

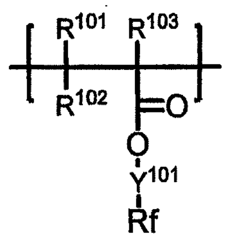

In General Formula (102), $R^{101}$, $R^{102}$, $R^{103}$, $Y^{101}$, and Rf each have the same definitions as in General Formula (101), and preferred embodiments thereof are also the same.

The perfluoroalkyl group-containing (meth)acrylic resin can arbitrarily select components to be copolymerized, in addition to the perfluoroalkyl group-containing (meth)acrylic ester from the viewpoint of peelability. Examples of the radically polymerizable compound capable of forming the components to be copolymerized include radically polymerizable compounds selected from acrylic esters, methacrylic esters, N,N-disubstituted acrylamides, N,N-disubstituted methacrylamides, styrenes, acrylonitriles, and methacrylonitriles.

More specific examples thereof include acrylic esters such as alkyl acrylates

(preferably containing an alkyl group having 1 to 20 carbon atoms) (for example, methyl acrylate, ethyl acrylate, propyl acrylate, butyl acrylate, amyl acrylate, ethylhexyl acrylate, octyl acrylate, t-octyl acrylate, chloroethyl acrylate, 2,2-dimethylhydroxypropyl acrylate, 5-hydroxypentyl acrylate, trimethylolpropane monoacrylate, pentaerythritol monoacrylate, glycidyl acrylate, benzyl acrylate, methoxybenzyl acrylate, furfuryl acrylate, and tetrahydrofurfuryl acrylate); aryl acrylates (for example, phenyl acrylate); methacrylic esters such as alkyl methacrylates (preferably containing an alkyl group having 1 to 20 carbon atoms) (for example, methyl methacrylate, ethyl methacrylate, propyl methacrylate, isopropyl methacrylate, amyl methacrylate, hexyl methacrylate, cyclohexyl methacrylate, benzyl methacrylate, chlorobenzyl methacrylate, octyl methacrylate, 4-hydroxybutyl methacrylate, 5-hydroxypentyl methacrylate, 2,2-dimethyl-3-hydroxypropyl methacrylate, trimethylolpropane monomethacrylate, pentaerythritol monomethacrylate, glycidyl methacrylate, furfuryl methacrylate, and tetrahydrofurfuryl methacrylate); aryl methacrylates (for example, phenyl methacrylate, cresyl methacrylate, and naphthyl methacrylate); styrenes such as styrene and alkyl styrene (for example, methylstyrene, dimethylstyrene, trimethylstyrene, ethylstyrene, diethylstyrene, isopropylstyrene, butylstyrene, hexylstyrene, cyclohexylstyrene, decylstyrene, benzyl styrene, chloromethylstyrene, trifluoromethylstyrene, ethoxymethylstyrene, and acetoxymethylstyrene); alkoxystyrenes (for example, methoxystyrene, 4-methoxy-3-methylstyrene, and dimethoxystyrene); halogen-containing styrenes (for example, chlorostyrene, dichlorostyrene, trichlorostyrene, tetrachlorostyrene, pentachlorostyrene, bromostyrene, dibromostyrene, iodostyrene, fluorostyrene, trifluorostyrene, 2-bromo-4-trifluoromethylstyrene, and 4-fluoro-3-trifluoromethylstyrene); acrylonitrile, methacrylonitrile; and carboxylic acid-containing radically polymerizable compounds (acrylic acid, methacrylic acid, itaconic acid, crotonic acid, isocrotonic acid, maleic acid, p-carboxylstyrene, metal salts of these acid groups, and ammonium salt compounds). However from the viewpoint of peelability, (meth)acrylic esters containing a hydrocarbon group having 1 to 24 carbon atoms are particularly preferable, and examples thereof include methyl (meth)acrylate, butyl(meth)acrylate, 2-ethylhexyl(meth)acrylate, lauryl (meth)acrylate, stearyl(meth)acrylate, and glycidyl esters, with (meth)acrylates, in particular, acrylates of higher hydric alcohols, such as 2-ethylhexyl (meth)acrylate, lauryl (meth)acrylate, and stearyl (meth)acrylate being preferable.

Examples of the polymer compound containing a fluorine atom with a non-three-dimensional crosslinked structure, that are commercially available, include fluororesins such as Teflon (registered trademark) (DuPont), Tefzel (Dupont), Fluon (Asahi Glass Co., Ltd.), Halar (Solvay Solexis Inc.), Hylar (SolvaySolexis Inc.), Lumiflon (Asahi Glass Co., Ltd.), Aflas (Asahi Glass Co., Ltd.), CEFRAL SOFT (Central Glass Co., Ltd.), and CEFRAL COAT (Central Glass Co., Ltd.); fluorine rubbers with trade names of Viton (DuPont), Kalrez (DuPont), SIFEL (Shin-Etsu Chemical Co., Ltd.), and the like; various fluorine oils including perfluoropolyether oils such as Krytox (DuPont), Fomblin (Daedeok Tech Co., Ltd.), and DEMNUM (Daikin Industries, Ltd.); and fluorine-containing releasing agents with trade names of DAIFREE FB series (Daikin Industries), Megaface series (DIC Corp.), and the like, but are not limited thereto. Any substance which is a polymer compound containing a fluorine atom with a non-three-dimensional crosslinked structure can also be suitably used.

The weight average molecular weight of the polymer compound containing a fluorine atom with a non-three-dimensional crosslinked structure, as determined by a gel permeation chromatography (GPC) method and calculated in terms of polystyrene, is preferably 100,000 to 2,000, more preferably 50,000 to 2,000, and most preferably 10,000 to 2,000.

From the viewpoint of good peelability, the content of the polymer compound containing a fluorine atom with

a non-three-dimensional crosslinked structure is preferably 1% by mass to 99% by mass, more preferably 3% by mass to 50% by mass, and still more preferably 5% by mass to 30% by mass, with respect to the total solid content of the protective layer.

One kind or two or more kinds of polymer compound containing a fluorine atom with a non-three-dimensional crosslinked structure may be used. In the case where two or more kinds of the polymer compound containing a fluorine atom with a non-three-dimensional crosslinked structure are used, the total sum thereof is preferably within the above range.

«Other Additives»

If desired, various additives such as a curing agent, a curing catalyst, a silane coupling agent, a filler, an adhesion promoting agent, an antioxidant, an ultraviolet absorber, and an anti-aggregation agent may be blended into the composition for forming a protective layer in the present invention within a range not interfering with the effects of the present invention. In the case of blending these additives, the total blending amount is preferably set to 3% by mass or less of the solid content of the composition for forming a protective layer.

<Release Layer>

The release layer is used for the purpose of making it possible to easily release the protective layer from the support substrate. Thus, the release layer is required to have low surface energy and a small change in adhesiveness for heat. Further, the release layer contains a fluorine atom and/or a silicon atom, is in contact only with the protective layer and the support substrate, and thus, is not in contact with other members. That is, the entire surface on one side of the release layer is in contact with the protective layer and the entire surface on the other side is in contact with the support substrate.

The release layer is a low-surface energy layer containing a fluorine atom and/or a silicon atom, and preferably has a material containing a fluorine atom and/or a silicon atom. The content of fluorine in the release layer is preferably 80% by mass to 30% by mass, more preferably 76% by mass to 40% by mass, and particularly preferably 75% by mass to 60% by mass.

The content of fluorine is defined as the mass of fluorine in one molecule/the mass of all the atoms in one fluorine.

From the viewpoint of heat resistance, the release layer preferably includes a three-dimensional crosslinked product. Among these, at least one of a radical polymerization product of a bifunctional or higher functional radically polymerizable monomer or oligomer containing a fluorine atom, and a condensate of an alkoxysilane compound containing a fluorine atom is preferable, and a three-dimensional crosslinked product of a fluorine-containing polyfunctional monomer/oligomer or a three-dimensional crosslinked product of a fluorine-containing silane coupling agent is particularly preferable. As the fluorine-containing silane coupling agent, a non-halogen-based silane coupling agent having a low the hazard to human bodies and metal corrosion is preferable, and a fluorine-containing alkoxysilane compound is particularly preferable. Further, examples of the halogen-based silane coupling agent include a fluorinated chlorosilane compound.

Hereinafter, the material containing a fluorine atom and/or a silicon atom, which can be included in the composition for forming a release layer will be described.

[Polymerizable Monomer Containing Fluorine Atom or Silicon Atom]

The polymerizable monomer in the present invention is particularly preferably a polymerizable monomer containing a fluorine atom or silicon atom. The polymerizable monomer containing a fluorine atom or a silicon atom is preferably a radically polymerizable monomer or oligomer containing one or more fluorine atoms or silicon atoms in one molecule, and particularly preferably a polymerizable monomer having a group, generally called perfluoro groups, in which two or more fluorine atoms are contained in one molecule.

The radically polymerizable monomer or oligomer containing a fluorine atom or a silicon atom has a radically polymerizable functional group, the radically polymerizable functional group is not particularly limited and is preferably one containing an unsaturated group (an ethylenically unsaturated bonding group or the like).

The radically polymerizable monomer or oligomer containing a fluorine atom or a silicon atom is preferably one containing two or more radically polymerizable functional groups, by which it is possible to further improve the peelability from a temporary support for the treated member after undergoing a process at a high temperature.

[[Polymerizable Compound Containing Fluorine Atom]]

The polymerizable compound containing a fluorine atom can be selected from known compounds, and is preferably a crosslinking agent having a polymerizable group as a crosslinkable group. Examples of the crosslinkable group include a silyl group having a hydroxy group or a hydrolyzable group (for example, an alkoxysilyl group and an

acyloxysilyl group), a group having a reactive unsaturated double bond (a (meth)acryloyl group, an allyl group, a vinyloxy group, or the like), a ring-opening polymerization reactive group (an epoxy group, an oxetanyl group, an oxazolyl group, or the like), a group having an active hydrogen atom (for example, a hydroxyl group, a carboxyl group, an amino group, a carbamoyl group, a mercapto group, a β-ketoester group, a hydrosilyl group, a silanol group, or the like), an acid anhydride, a group which can be substituted with a nucleophilic agent (an active halogen atom, a sulfonic acid ester, or the like), or the like.

The radically polymerizable monomer containing a fluorine atom is preferably a compound represented by the following General Formula (1).

General Formula (1): Rf{-L-Y}n

(in which Rf represents a chained or cyclic n-valent group which may contained any one of an oxygen atom and a hydrogen atom, including at least a carbon atom and a fluorine atom, n represents an integer of 2 or more, L represents a single bond or a divalent linking group, and Y represents a polymerizable group).

In General Formula (1), Y is preferably a polymerizable group, and examples thereof include a silyl group having a hydroxy group or a hydrolyzable group (for example, an alkoxysilyl group and an acyloxysilyl group), a group having a reactive unsaturated double bond (a (meth)acryloyl group, an allyl group, a vinyloxy group, or the like), a ring-opening polymerization reactive group (an epoxy group, an oxetanyl group, an oxazolyl group, or the like), a group having an active hydrogen atom (a hydroxyl group, a carboxyl group, an amino group, a carbamoyl group, a mercapto group, a β-ketoester group, a hydrosilyl group, a silanol group, or the like), an acid anhydride, a group which can be substituted with a nucleophilic agent (an active halogen atom, a sulfonic acid ester, or the like), or the like.

Y is more preferably a radically polymerizable group, and still more preferably a group having a reactive unsaturated double bond. Specifically, T preferably represents a radically polymerizable functional group represented by the following General Formula (9).

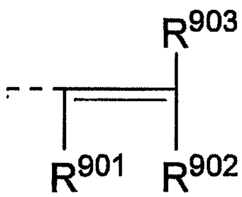

(9)

(in General Formula (9), $R^{901}$ to $R^{903}$ each independently represent a hydrogen atom, an alkyl group, or an aryl group. The dotted line represents a bond to a group linking to L).

As an example of the alkyl group, it is preferably an alkyl group having 1 to 8 carbon atoms, and examples thereof include a methyl group, an ethyl group, a propyl group, an octyl group, an isopropyl group, a tert-butyl group, an isopentyl group, a 2-ethylhexyl group, a 2-methylhexyl group, and a cyclopentyl group. As an example of the aryl group, an aryl group having 6 to 12 carbon atoms is preferable, and examples thereof include a phenyl group, a 1-naphthyl group, and a 2-naphthyl group. Among them, as $R^{901}$ to $R^{903}$, a hydrogen atom or a methyl group is preferable.

L represents a single bond or a divalent linking group. The divalent linking group represents a divalent aliphatic group, a divalent aromatic group, -O-, -S-, -CO-, -N(R)-, and a divalent linking group obtained by combination of two or more kinds of these groups. Here, R represents a hydrogen atom or an alkyl group having 1 to 5 carbon atoms.

In the case where L has an alkylene group or an arylene group, the alkylene group and the arylene group is preferably substituted with a halogen atom, and more preferably substituted with a fluorine atom.

Rf represents a chained or cyclic n-valent group which contains at least a carbon atom and a fluorine atom, and may contain any one of an oxygen atom and a hydrogen atom. Rf may be a linear or branched polymer structure having a repeating unit containing a fluorine atom.

As the monomer containing a fluorine atom, the compounds described in paragraphs "0019" to "0033" of JP2011-48358A can also be preferably used, the contents of which are incorporated herein.

Further, the radically polymerizable monomer containing a fluorine atom is preferably at least one selected from the compounds represented by the following Structural Formulae (1), (2), (3), (4), and (5).

$CH_2=CR^1COOR^2R^f$ ... Structural Formula (1)

(in Structural Formula (1), $R^1$ represents a hydrogen atom or a methyl group, $R^2$ represents $-C_pH_{2p}-$, $-C(C_pH_{2p+1})H-$,

$-CH_2C(C_pH_{2p+1})H-$, or $-CH_2CH_2O-$ and $R^f$ represents $-C_nF_{2n+1}$, $-(CF_2)_nH$, $-C_nF_{2n+1}-CF_3$, $-(CF_2)_pOC_nH_{2n}C_iF_{2i+1}$, $-(CF_2)_pOC_mH_{2m}C_iF_{2i}H$, $-N(C_pH_{2p+1})COC_nF_{2n+1}$, or $-N(C_pH_{2p+1})SO_2C_nF_{2n+1}$, in which p is an integer of 1 to 10, n is an integer of 1 to 16, m is an integer of 0 to 10, and i is an integer of 0 to 16).

$CF_2=CFOR^g$ ... Structural Formula (2)

(in Structural Formula (2), $R^g$ represents a fluoroalkyl group having 1 to 20 carbon atoms).

$CH_2=CHR^g$ ... Structural Formula (3)

(in Structural Formula (3), $R^g$ represents a fluoroalkyl group having 1 to 20 carbon atoms).

$CH_2=CR^3COOR^5R^jR^6OCOCR^4=CH_2$ ... Structural Formula (4)

(in Structural Formula (4), $R^3$ and $R^4$ each independently represent a hydrogen atom or a methyl group, $R^5$ and $R^6$ each independently represent $-C_qH_{2q}-$, $-C(C_qH_{2q+1})H-$, $-CH_2C(C_qH_{2q+1})H-$ or $-CH_2CH_2O-$, and $R_j$ represents $-C_tF_{2t}$, in which q is an integer of 1 to 10 and t is an integer of 1 to 16).

$CH_2=CHR^7COOCH_2(CH_2R^k)CHOCOCR^8=CH_2$ ... Structural Formula (5)

(in Structural Formula (5), $R^7$ and $R^8$ each independently represent a hydrogen atom or a methyl group, and $R^k$ is $-CyF_{2y+1}$, in which y is an integer of 1 to 16).

Examples of the monomer represented by Structural Formula (1) include $CF_3(CF_2)_5CH_2CH_2OCOCH=CH_2$, $CF_3CH_2OCOCH=CH_2$, $CF_3(CF_2)_4CH_2CH_2OCOC(CH_3)=CH_2$, $C_7F_{15}CON(C_2H_5)CH_2OCOC(CH_3)=CH_2$, $CF_3(CF_2)_7SO_2N(CH_2)CH_2CH_2OCOCH=CH2$, $CF_2(CF_2)_7SO_2N(C_3H_7)CH_2CH_2OCOCH=CH_2$, $C_2F_5SO_2N(C_3H_7)CH_2CH_2OCOC(CH_3)=CH_2$, $(CF_3)_2CF(CF_2)_6(CH_2)_3OCOCH=CH_2$, $(CF_3)_2CF(CF_2)_{10}(CH_2)_3OCOC(CH_3)=CH_2$, $CF_3(CF_2)_4CH(CH_3)OCOC(CH_3)=CH_2$, $CF_3CH_2OCH_2CH_2OCOCH=CH_2$, $C_2F_5(CH_2CH_2O)_2CH_2OCOCH=CH_2$, $(CF_3)_2CFO(CH_2)_5OCOCH=CH_2$, $CF_3(CF_2)_4OCH_2CH_2OCOC(CH_3)=CH_2$, $C_2F_5CON(C_2H_5)CH_2OCOCH=CH_2$, $CF_3(CF_2)_2CON(CH_3)CH(CH_3)CH_2OCOCH=CH_2$, $H(CF_2)_6C(C_2H_5)OCOC(CH_3)=CH_2$, $H(CF_2)_8CH_2OCOCH=CH_2$, $H(CF_2)_4CH_2OCOCH=CH_2$, $H(CF_2)CH_2OCOC(CH_3)=CH_2$, $CF_3(CF_2)_7SO_2N(CH_3)CH_2CH_2OCOC(CH_3)=CH_2$, $CF_3(CF_2)_7SO_2N(CH_3)(CH_2)_{10}OCOCH=CH_2$, $C_2F_5SO_2N(C_2H_5)CH_2CH_2OCOC(CH_3)=CH_2$, $CF_3(CF_2)_7SO_2N(CH_3)(CH_2)_4OCOCH=CH_2$, and $C_2F_5SO_2N(C_2H_5)C(C_2H_5)HCH_2OCOCH=CH_2$. These may be used singly or in combination of two or more kinds thereof.

Examples of the fluoroalkylated olefin represented by Structural Formula (2) or (3) include $C_3F_7CH=CH_2$, $C_4F_9CH=CH_2$, $C_{10}F_{21}CH=CH_2$, $C_3F_7OCF=CF_2$, $C_7F_{15}OCF=CF_2$, and $C_8F_{17}OCF=CF_2$.

Examples of the monomer represented by Structural Formula (4) or (5) include $CH_2-CHCOOCH_2(CF_2)_3CH_2OCOCH=CH_2$, $CH_2=CHCOOCH_2(CF_2)_6CH_2OCOCH=CH_2$, and $CH_2=CHCOOCH_2CH(CH_2C_8F_{17})OCOCH=CH_2$.

Furthermore, as the radically polymerizable monomer or oligomer containing a fluorine atom, an oligomer having a repeating unit containing a fluorine atom and a repeating unit having a radically polymerizable functional group can be preferably used.

As the repeating unit containing a fluorine atom, one selected from at least one of the repeating units represented by the following Formulae (6), (7), and (10) is preferable.

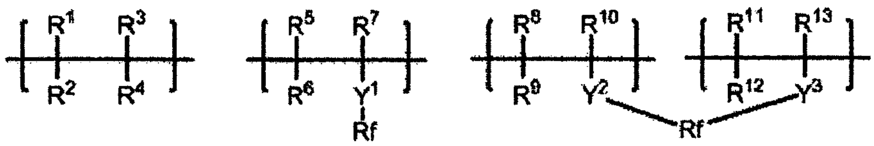

(6) (7) (10)

In Formula (6), $R^1$, $R^2$, $R^3$, and $R^4$ each independently represent a hydrogen atom, a halogen atom, a hydroxyl group, or a monovalent organic group, and at least one of $R^1$, $R^2$, $R^3$, and $R^4$ is a fluorine atom, or a monovalent organic group containing a fluorine atom. In Formula (7), $R^5$, $R^6$, and $R^7$ each independently represent a hydrogen atom, a halogen atom, a hydroxyl group, or a monovalent organic group, Y1 represents a single bond, or a divalent linking group selected from the group consisting of -CO-, -O-, -NH-, a divalent aliphatic group, a divalent aromatic group, and a

combination thereof. Rf represents a fluorine atom, or a monovalent organic group containing a fluorine atom. In Formula (10), $R^8$, $R^9$, $R^{10}$, $R^{11}$, $R^{12}$, and $R^{13}$ each independently represent a hydrogen atom, a halogen atom, a hydroxyl group, or a monovalent organic group, $Y^2$ and $Y^3$ represents a single bond, or a divalent linking group selected from the group consisting of -CO-, -O-, -NH-, a divalent aliphatic group, a divalent aromatic group, and a combination thereof, and Rf represents a divalent organic group containing a fluorine atom.

The monovalent organic group containing a fluorine atom in Formulae (6) and (7) is not particularly limited, and a fluorine-containing alkyl group having 1 to 30 carbon atoms is preferable, a fluorine-containing alkyl group having 1 to 20 carbon atoms is more preferable, and a fluorine-containing alkyl group having 1 to 15 carbon atoms is particularly preferable. This fluorine-containing alkyl group may be linear (for example, $-CF_2CF_3$, $-CH_2(CF_2)_4H$, $-CH_2(CF_2)_8CF_3$, and $-CH_2CH_2(CF_2)_4H$), may have a branched structure (for example, $-CH(CF_3)_2$, $-CH_2CF(CF_3)_2$, $-CH(CH_3)CF_2CF_3$, and $-CH(CH_3)(CF_2)_5CF_2H$), may have an alicyclic structure (preferably a 5- or 6-membered ring, for example, a perfluorocyclohexyl group, a perfluorocyclopentyl group, and an alkyl group substituted therewith), and may have an ether bond (for example, $-CH_2OCH_2CF_2CF_3$, $-CH_2CH_2OCH_2C_4F_8H$, $-CH_2CH_2OCH_2CH_2C_8F_{17}$, and $-CH_2CF_2OCF_2CF_2OCF_2CF_2H$). Further, it may be a perfluoroalkyl group.

The divalent organic group containing a fluorine atom in Formula (10) is not particularly limited, and is preferably a fluorine-containing alkylene group having 1 to 30 carbon atoms, more preferably a fluorine-containing alkylene group having 1 to 20 carbon atoms, and particularly preferably a fluorine-containing alkylene group having 1 to 15 carbon atoms. The fluorine-containing alkylene group may have a linear structure (for example, $-CF_2CF_2-$, $-CH_2(CF_2)_4-$, $-CH_2(CF_2)_8CF_2-$, and $-CH_2CH_2(CF_2)_4-$) or a branched structure (for example, $-CH(CF_3)CF_2-$, $-CH_2CF(CF_3)CF_2-$, $-CH(CH_3)CF_2CF_2-$, and $-CH(CH_3)(CF_2)5CF_2-$), and may also be a linking group having an alicyclic structure (preferably a 5- or 6-membered ring, for example, a perfluorocyclohexyl group, a perfluorocyclopentyl group, or an alkyl group substituted therewith) and may have an ether bond (for example, $-CH_2OCH_2CF_2CF_2-$, $-CH_2CH_2OCH_2C_4F_8-$, $-CH_2CH_2OCH_2CH_2C_8F_{16}-$, $-CH_2CF_2OCF_2CF_2OCF_2CF_2-$, $-CH_2CF_2OCF_2CF_2OCF_2CF_2-$, and a polyperfluoroalkylene ether chain). Further, the fluorine-containing alkylene group may be a perfluoroalkylene group.

The monovalent organic group in Formulae (6), (7), and (10) is preferably an organic group constituting from 3- to 10-valent nonmetallic atoms, and examples thereof include an organic group constituted with at least one element selected from 1 to 60 carbon atoms, 0 to 10 nitrogen atoms, 0 to 50 oxygen atoms, 1 to 100 hydrogen atoms and 0 to 20 sulfur atoms.

More specific examples of the monovalent organic group include organic groups having the structures shown below and organic groups constituted with one or a combination of two or more of the following structures.

The monovalent organic group may further have a substituent, and examples of the substituent which may be introduced include a halogen atom, a hydroxy group, a carboxy group, a sulfonate group, a nitro group, a cyano group, an amido group, an amino group, an alkyl group, an alkenyl group, an alkynyl group, an aryl group, a substituted oxy group, a substituted sulfonyl group, a substituted carbonyl group, a substituted sulfinyl group, a sulfo group, a phosphono group, a phosphonate group, a silyl group, and a heterocyclic group. Further, the organic group may also contain an ether bond, an ester bond, or a ureido bond.

The monovalent organic group is preferably an alkyl group, an alkenyl group, an alkynyl group or an aryl group. The alkyl group is preferably an alkyl group having 1 to 8 carbon atoms, and examples thereof include a methyl group, an ethyl group, a propyl group, an octyl group, an isopropyl group, a t-butyl group, an isopentyl group, a 2-ethylhexyl group, a 2-methylhexyl group, and a cyclopentyl group. The alkenyl group is preferably an alkenyl group having 2 to 20 carbon atoms, and examples thereof include a vinyl group, an allyl group, a prenyl group, a geranyl group, and an oleyl group. The alkynyl group is preferably an alkynyl group having 3 to 10 carbon atoms, and examples thereof include an ethynyl group, a propargyl group, and a trimethylsilylethynyl group. The aryl group is preferably an aryl group having 6 to 12 carbon atoms, and examples thereof include a phenyl group, a 1-naphthyl group, and a 2-naphthyl group. The heterocyclic group is preferably a heterocyclic group having 2 to 10 carbon atoms, and examples thereof include a furanyl group, a thiophenyl group, and a pyridinyl group.

The monovalent organic groups represented by $R^1$, $R^2$, $R^3$, and $R^4$ in Formula (6), $R^5$, $R^6$, and $R^7$ in Formula (7), and $R^8$, $R^9$, $R^{10}$, $R^{11}$, $R^{12}$, and $R^{13}$ in Formula (10) are preferably an alkyl group or an aryl group.

The alkyl group is preferably an alkyl group having 1 to 8 carbon atoms, and examples thereof include a methyl group, an ethyl group, a propyl group, an octyl group, an isopropyl group, a tert-butyl group, an isopentyl group, a 2-ethylhexyl group, a 2-methylhexyl group, and a cyclopentyl group. As the aryl group, an aryl group having 6 to 12 carbon atoms is preferable, and examples thereof include a phenyl group, a 1-naphthyl group, and a 2-naphthyl group. $R^{901}$ to $R^{903}$ are preferably a hydrogen atom or a methyl group.

Specific examples of the divalent linking group selected from the group consisting of -CO-, -O-, -NH-, the divalent aliphatic group, the divalent aromatic group, and a combination thereof represented by $Y^1$ in Formula (7) and $Y^2$ and $Y^3$ in Formula (10) include the following groups. Further, in the following examples, the left side connects to the main chain and the right side connects to Rf.

L1: -CO-NH-divalent aliphatic group-O-CO-NH-divalent aliphatic group-O-CO-
L2: -CO-NH-divalent aliphatic group-O-CO-
L3: -CO-divalent aliphatic group-O-CO-
L4: -CO-O-divalent aliphatic group-O-CO-
L5: -divalent aliphatic group-O-CO-
L6: -CO-NH-divalent aromatic group-O-CO-
L7: -CO-divalent aromatic group-O-CO-
L8: -divalent aromatic group-O-CO-
L9: -CO-O-divalent aliphatic group-CO-O-divalent aliphatic group-O-CO-
L10: -CO-O-divalent aliphatic group-O-CO-divalent aliphatic group-O-CO-
L11: -CO-O-divalent aromatic group-CO-O-divalent aliphatic group-O-CO-
L12: -CO-O-divalent aromatic group-O-CO-divalent aliphatic group-O-CO-
L13: -CO-O-divalent aliphatic group-CO-O-divalent aromatic group-O-CO-
L14: -CO-O-divalent aliphatic group-O-CO-divalent aromatic group-O-CO-
L 15: -CO-O-divalent aromatic group-CO-O-divalent aromatic group-O-CO-
L16: -CO-O-divalent aromatic group-O-CO-divalent aromatic group-O-CO-
L17: -CO-O-divalent aromatic group-O-CO-NH-divalent aliphatic group-O-CO-
L18: -CO-O-divalent aliphatic group-O-CO-NH-divalent aliphatic group-O-CO-
L19: -divalent aromatic group-divalent aliphatic group-
L20: -divalent aromatic group-divalent aliphatic group-O-divalent aliphatic group-
L21: -divalent aromatic group-divalent aliphatic group-O-divalent aliphatic group-O-
L22: -CO-O-divalent aliphatic group-
L23: -CO-O-divalent aliphatic group-O-

Here, the divalent aliphatic group means an alkylene group, a substituted alkylene group, an alkenylene group, a substituted alkenylene group, an alkynylene group, a substituted alkynylene group, or a polyalkyleneoxy group. Among these, an alkylene group, a substituted alkylene group, an alkenylene group, and a substituted alkenylene group are preferable, and an alkylene group and a substituted alkylene group are more preferable.

As the divalent aliphatic groups, a chained structure is preferred to a cyclic structure, and a linear structure is preferred to a chained structure having a branch. The number of carbon atoms contained in the divalent aliphatic group is preferably 1 to 20, more preferably 1 to 15, still more preferably 1 to 12, even still more preferably 1 to 10, even still more preferably 1 to 8, and particularly preferably 1 to 4.

Examples of the substituent for the divalent aliphatic group include a halogen atom (F, Cl, Br, or I), a hydroxy group, a carboxyl group, an amino group, a cyano group, an aryl group, an alkoxy group, an aryloxy group, an acyl group, an alkoxycarbonyl group, an aryloxycarbonyl group, an acyloxy group, a monoalkylamino group, a dialkylamino group, an arylamino group, and a diarylamino group.

Examples of the divalent aromatic group include a phenylene group, a substituted phenylene group, a naphthylene group and a substituted naphthylene group, with the phenylene group being preferable. Examples of the substituent for the divalent aromatic group include an alkyl group in addition to the substituents described for the divalent aliphatic group above.

The content of the repeating unit containing a fluorine atom is preferably 2% by mole to 98% by mole, and more preferably 10% by mole to 90% by mole, with respect to the total repeating units of the radically polymerizable oligomer containing a fluorine atom.

The repeating unit containing a radically polymerizable functional group is preferably a repeating unit represented by the following Formula (8).

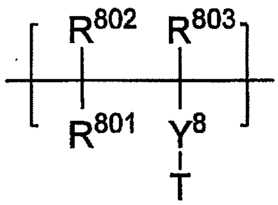 (8)

(in General Formula (8), $R^{801}$ to $R^{803}$ each independently represent a hydrogen atom, an alkyl group, or a halogen atom, $Y^8$ represents a single bond, or a divalent linking group selected from the group consisting of -CO-, -O-, -NH-, a divalent aliphatic group, a divalent aromatic group, and a combination thereof, and T represents a structure having a radically polymerizable functional group)

The alkyl group represented by $R^{801}$ to $R^{803}$ is preferably an alkyl group having 1 to 6 carbon atoms.

T preferably represents a radically polymerizable functional group represented by General Formula (9).

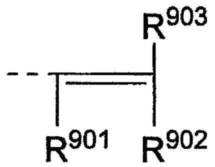

(9)

(in General Formula (9), $R^{901}$ to $R^{903}$ each independently represent a hydrogen atom, an alkyl group, or an aryl group, and the dotted line represents a bond to a group linking to $Y^8$)

The alkyl group is preferably an alkyl group having 1 to 8 carbon atoms, and examples thereof include a methyl group, an ethyl group, a propyl group, an octyl group, an isopropyl group, a tert-butyl group, an isopentyl group, a 2-ethylhexyl group, a 2-methylhexyl group and a cyclopentyl group. The aryl group is preferably an aryl group having 6 to 12 carbon atoms, and examples thereof include a phenyl group, a 1-naphthyl group, and a 2-naphthyl group. Among these, $R^{901}$ to $R^{903}$ are preferably a hydrogen atom or a methyl group.

$Y^8$ represents a single bond or a divalent linking group selected from the group consisting of -CO-, -O-, -NH-, a divalent aliphatic group, a divalent aromatic group, and a combination thereof. Specific examples of the combination of groups represented by $Y^8$ are set forth below. Further, in the following examples, the left side is bonded to the main chain and the right side is bonded to Formula (9).

L1: -CO-NH-divalent aliphatic group-O-CO-NH-divalent aliphatic group-O-CO-
L2: -CO-NH-divalent aliphatic group-O-CO-
L3: -CO-divalent aliphatic group-O-CO-
L4: -CO-O-divalent aliphatic group-O-CO-
L5: -divalent aliphatic group-O-CO-
L6: -CO-NH-divalent aromatic group-O-CO-
L7: -CO-divalent aromatic group-O-CO-
L8: -divalent aromatic group-O-CO-
L9: -CO-O-divalent aliphatic group-CO-O-divalent aliphatic group-O-CO-
L10: -CO-O-divalent aliphatic group-O-CO-divalent aliphatic group-O-CO-
L11: -CO-O-divalent aromatic group-CO-O-divalent aliphatic group-O-CO-
L12: -CO-O-divalent aromatic group-O-CO-divalent aliphatic group-O-CO-
L13: -CO-O-divalent aliphatic group-CO-O-divalent aromatic group-O-CO-
L14: -CO-O-divalent aliphatic group-O-CO-divalent aromatic group-O-CO-
L15: -CO-O-divalent aromatic group-CO-O-divalent aromatic group-O-CO-
L16: -CO-O-divalent aromatic group-O-CO-divalent aromatic group-O-CO-
L17: -CO-O-divalent aromatic group-O-CO-NH-divalent aliphatic group-O-CO-
L18: -CO-O-divalent aliphatic group-O-CO-NH-divalent aliphatic group-O-CO-

Here, the divalent aliphatic group means an alkylene group, a substituted alkylene group, an alkenylene group, a substituted alkenylene group, an alkynylene group, a substituted alkynylene group, or a polyalkyleneoxy group. Among these, an alkylene group, a substituted alkylene group, an alkenylene group and a substituted alkenylene group are preferred, and an alkylene group and a substituted alkylene group are more preferable.

As the divalent aliphatic group, a chained structure is preferred to a cyclic structure, and a linear structure is preferred to a chained structure having a branch. The number of carbon atoms contained in the divalent aliphatic group is preferably 1 to 20, more preferably 1 to 15, still more preferably 1 to 12, even still more preferably 1 to 10, even still more preferably 1 to 8, and particularly preferably 1 to 4.

Examples of the substituent for the divalent aliphatic group include a halogen atom (F, Cl, Br, or I), a hydroxy group, a carboxyl group, an amino group, a cyano group, an aryl group, an alkoxy group, an aryloxy group, an acyl group, an alkoxycarbonyl group, an aryloxycarbonyl group, an acyloxy group, a monoalkylamino group, a dialkylamino group, an arylamino group, and a diarylamino group.

Examples of the divalent aromatic group include a phenylene group, a substituted phenylene group, a naphthylene group and a substituted naphthylene group, with a phenylene group being preferable. Examples of the substituent for the divalent aromatic group include an alkyl group, in addition to the substituents described for the divalent aliphatic group above.

The content of the repeating unit containing a radically polymerizable functional group is preferably 2% by mole

to 98% by mole, and more preferably 10% by mole to 90% by mole, with respect to the total repeating units of the radically polymerizable oligomer containing a fluorine atom.

The weight average molecular weight of the radically polymerizable oligomer containing a fluorine atom, as determined by a gel permeation chromatography (GPC) method and calculated in terms of polystyrene, is preferably 2,000 to 20,000, more preferably 2,000 to 15,000, and most preferably 2,000 to 10,000.

The weight average molecular weight of the radically polymerizable oligomer containing a fluorine atom, as determined by a gel permeation chromatography (GPC) method and calculated in terms of polystyrene, is preferably 2,000 to 10,000, more preferably 8,000 to 2,000, and most preferably 6,000 to 2,000.

In the case where the composition for forming a release layer contains a radically polymerizable monomer or oligomer containing a fluorine atom, the content of the radically polymerizable monomer or oligomer containing a fluorine atom is not particularly limited and is preferably 0.01% by mass to 15% by mass, with respect to the total solid content of the composition for forming a release layer. When the content is less than 0.01% by mass, the peelability tends to be insufficient, whereas when the content is more than 15% by mass, the adhesiveness tends to decrease.

One kind or two or more kinds of the radically polymerizable monomer or oligomer containing a fluorine atom may be used. In the case where two or more kinds of the radically polymerizable monomer or oligomer containing a fluorine atom are used, the total amount is preferably within the above range.

[Radically Polymerizable Monomer or Oligomer Containing Silicon Atom]

The radically polymerizable monomer or oligomer containing a silicon atom in the present invention is preferably a silicone monomer or a silicone oligomer, and examples thereof include a compound in which at least one terminal of polydimethylsiloxane bond is an ethylenically unsaturated group such as a (meth)acryloyl group and a styryl group, with a compound containing a (meth)acryloyl group being preferable.

The number average molecular weight of the radically polymerizable oligomer containing a silicon atom, as determined by a gel permeation chromatography method and calculated in terms of polystyrene, is preferably 1,000 to 10,000. When the number average molecular weight of the radically polymerizable oligomer containing a silicon atom, as determined by a gel permeation chromatography method and calculated in terms of polystyrene, is less than 1,000 or 10,000 or more, it becomes difficult the properties such as the peelability due to the silicon atom are developed.

As the radically polymerizable monomer containing a silicon atom in the present invention, a compound represented by General Formula (11) or (12) is preferably used.

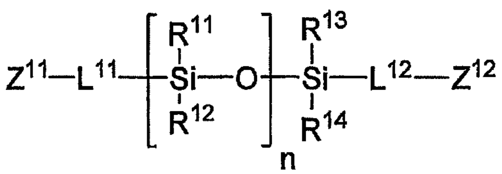

(11)

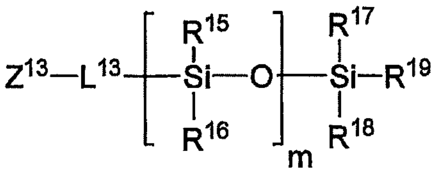

(12)

(in General Formulae (11) and (12), $R^{11}$ to $R^{19}$ each independently represent a hydrogen atom, an alkyl group, alkoxy group, an alkoxycarbonyl group, or an aryl group, $Z^{11}$, $Z^{12}$, and $Z^{13}$ each independently represent a radically polymerizable group, $L^{11}$, $L^{12}$, and $L^{13}$ each independently represent a single bond or a divalent linking group, and n and m each independently represent an integer of 0 or more)

In General Formulae (11) and (12), $R^{11}$ to $R^{19}$ each independently represent a hydrogen atom, an alkyl group, an alkoxy group, an alkoxycarbonyl group, or an aryl group.

The alkyl group represented by $R^{11}$ to $R^{19}$ may be linear or branched and is preferably an alkyl group having 1 to 5 carbon atoms, and specific examples thereof include a methyl group, an ethyl group, an n-propyl group, and an isopropyl group. The alkoxy group is represented by $-OR^{20}$, in which $R^{20}$ represents an alkyl group (preferably an alkyl group having 1 to 5 carbon atoms), and specific examples thereof include a methoxy group, an ethoxy group, a propoxy group, an isopropoxy group, and a butoxy group. The alkoxycarbonxyl group is represented by $-C(=O)R^{21}$, in which $R^{21}$ represents an alkoxy group (preferably an alkoxy group having 1 to 5 carbon atoms), and specific examples thereof include a methoxycarbonyl group, an ethoxycarbonyl group, and a propoxycarbonyl group. Examples of the aryl group include a phenyl group, a tolyl group, and a naphthyl group, each of which may have a substituent, and examples thereof include a phenylmethyl(benzyl) group, a phenylethyl group, a phenylpropyl group, a phenylbutyl group, and a naphthylmethyl group.

$L^{11}$, $L^{12}$, and $L^{13}$ each independently represent a single bond or a divalent linking group. The divalent linking group represents a divalent linking group selected from the group consisting of -CO-, -O-, -NH-, a divalent aliphatic

group, a divalent aromatic group, and a combination thereof.
n and m each independently represent an integer of 0 or more, and is preferably an integer of 0 to 100, and more preferably an integer of 0 to 50.

$Z^{11}$, $Z^{12}$, and $Z^{13}$ each independently represent a radically polymerizable group, and is particularly preferably a functional group represented by any one of the following General Formulae (i) to (iii).

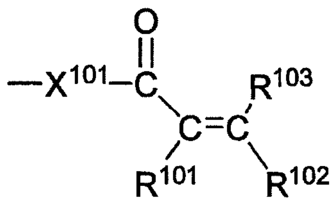

(i)

(in General Formula (i), $R^{101}$ to $R^{103}$ each independently represent a hydrogen atom or a monovalent organic group, $X^{101}$ represents an oxygen atom, a sulfur atom, or -N($R^{104}$)-, and $R^{104}$ represents a hydrogen atom or a monovalent organic group)

In General Formula (I), $R^{101}$ to $R^{103}$ each independently represent a hydrogen atom or a monovalent organic group. Preferred examples of $R^{101}$ include a hydrogen atom and an alkyl group which may have a substituent, and among these, a hydrogen atom or a methyl group is preferable due to high radical reactivity. Further, $R^{102}$ and $R^{103}$ each independently preferably represent a hydrogen atom, a halogen atom, an amino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent or an arylsulfonyl group which may have a substituent, and among these, a hydrogen atom, a carboxyl group, an alkoxycarbonyl group, an alkyl group which may have a substituent, or an aryl group which may have a substituent is preferable due to high radical reactivity.

$X^{101}$ represents an oxygen atom, a sulfur atom, or -N($R^{104}$)-, and $R^{104}$ represents a hydrogen atom or a monovalent organic group. Examples of the monovalent organic group include an alkyl group which may have a substituent. $R^{104}$ is preferably a hydrogen atom, a methyl group, an ethyl group, or an isopropyl group due to high radical reactivity.

Examples of the substituent which may be introduced include an alkyl group, an alkenyl group, an alkynyl group, an aryl group, an alkoxy group, an aryloxy group, a halogen atom, an amino group, an alkylamino group, an arylamino group, a carboxyl group, an alkoxycarbonyl group, a sulfo group, a nitro group, a cyano group, an amido group, an alkylsulfonyl group, and an arylsulfonyl group.

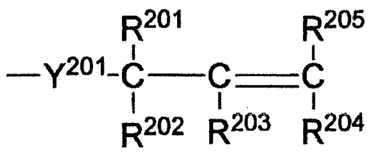

(ii)

(in General Formula (ii), $R^{201}$ to $R^{205}$ each independently represent a hydrogen atom or a monovalent organic group, $Y^{201}$ represents an oxygen atom, a sulfur atom, or -N($R^{206}$)-, and $R^{206}$ represents a hydrogen atom or a monovalent organic group)

In General Formula (ii), $R^{201}$ to $R^{205}$ each independently represent a hydrogen atom or a monovalent organic group. $R^{201}$ to $R^{205}$ are each independently preferably a hydrogen atom, a halogen atom, an amino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent, and more preferably a hydrogen atom, a carboxyl group, an alkoxycarbonyl group, an alkyl group which may have a substituent, or an aryl group which may have a substituent.

Examples of the substituent which may be introduced include the same ones as the substituents described in General Formula (i).

$Y^{201}$ represents an oxygen atom, a sulfur atom, or -N($R^{206}$)-, $R^{206}$ has the same definition as $R^{104}$ in General Formula (i) and preferred examples thereof are also the same.

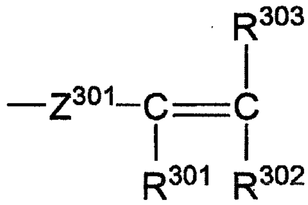

(iii)

(in General Formula (iii), $R^{301}$ to $R^{303}$ each independently represent a hydrogen atom or a monovalent organic group, $Z^{301}$ represents an oxygen atom, a sulfur atom, -N($R^{304}$)-, or a phenylene group which may have a substituent, and $R^{304}$ has the same definition as $R^{104}$ in General Formula (i))

In General Formula (iii), $R^{301}$ to $R^{303}$ each independently represent a hydrogen atom or a monovalent organic group. $R^{301}$ is preferably a hydrogen atom, an alkyl group which may have a substituent or the like, and among these, a hydrogen atom or a methyl group is more preferable due to high radical reactivity. $R^{302}$ and $R^{303}$ are each preferably a hydrogen atom, a halogen atom, an amino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent, or an arylsulfonyl group which may have a substituent, and a hydrogen atom, a carboxyl group, an alkoxycarbonyl group, an alkyl group which may have a substituent, or an aryl group which may have a substituent is more preferable due to high radical reactivity.

Examples of the substituent which can be introduced include the substituents described in General Formula (i). $Z^{301}$ represents an oxygen atom, a sulfur atom, -N($R^{304}$)-, or a phenylene group which may have a substituent. $R^{304}$ has the same definition as $R^{104}$ in General Formula (i), and examples of the monovalent organic group include an alkyl group which may have a substituent, and among these, a methyl group, an ethyl group, or an isopropyl group is preferable due to high radical reactivity.

In the case where the composition for forming a release layer has a radically polymerizable monomer or oligomer containing a silicon atom, the content of the radically polymerizable monomer or oligomer containing a silicon atom is from 0.01% by mass to 15% by mass, with respect to the total solid of the composition for forming a release layer. When the content is less than 0.01% by mass, the peelability tends to decrease, whereas the content is more than 15% by mass, the adhesiveness tends to decrease.

One kind or two or more kinds of the radically polymerizable compound containing a silicon atom may be used. In the case where two or more kinds of the radically polymerizable compound containing a silicon atom are used, the total amount thereof is preferably within the above range.

Examples of the radically polymerizable monomer containing a fluorine atom or a silicon atom include RS-75, RS-72-K, RS-76-E, and RS-72-K, manufactured by DIC Corporation, OPTOOL DAC-HP manufactured by Daikin Industries, Ltd., X-22-164, X-22-164AS, X-22-164A, X-22-164B, X-22-164C, and X-22-164E, manufactured by Shin-Etsu Chemical Co., Ltd., EBECRYL 350 and EBECRYL 1360, manufactured by Daicel-Cytec Co., Ltd., TEGO Rad 2700 manufactured by Degussa Co., and UV-3500B (manufactured by BYK-Chemie).

Examples of the material having a fluorine atom or a silicon atom include, in addition to those as described, heptadecafluoro-1,1,2-tetrahydrodecyl trichlorosilane, (fluoro)alkyl phosnate, perylene fluoride, a silicone/acrylate copolymer, copolymers of tetrafluoroethylene and 2,2-bis-trifluoromethyl-4,5-difluoro-1,3-dioxole, a polymer having a pendant perfluoroalkoxy group, and an ethylene fluoride-propylene copolymer.

The content of the material containing a fluorine atom and/or a silicon atom is preferably 5% by mass to 100% by mass, more preferably 50% by mass to 100% by mass, and still more preferably 90% by mass to 100% by mass, with respect to the total solid content of the release layer, from the viewpoint of good peelability.

One kind or two or more kinds of the material containing a fluorine atom and/or a silicon atom may be used. In the case where two or more kinds of material containing a fluorine atom and/or a silicon atom are used, the total sum thereof is preferably within the above range.

<Polymer Compound with Non-Three-Dimensional Crosslinked Structure Containing Fluorine Atom>

The release layer of the present invention preferably includes a polymer compound with a non-three-dimensional crosslinked structure containing a fluorine atom. Further, for a preferred aspect of the polymer compound with a non-three-dimensional crosslinked structure containing a fluorine atom, reference can be made to those described for the polymer compound with a non-three-dimensional crosslinked structure containing a fluorine atom, included in the aforementioned protective layer, a preferred range thereof is also the same.

From the viewpoint of good peelability, the content of the polymer compound with a non-three-dimensional

crosslinked structure containing a fluorine atom is preferably 1% by mass to 99% by mass, more preferably 3% by mass to 95% by mass, and still more preferably 5% by mass to 90% by mass, with respect to the total solid content of the release layer.

One kind or two or more kinds of the polymer compound containing a fluorine atom with a non-three-dimensional crosslinked structure may be used. In the case where two or more kinds of the polymer compound containing a fluorine atom with a non-three-dimensional crosslinked structure are used, the total sum thereof is preferably within the above range.

In the present invention, the ratio (mass ratio) of the fluorine atom-containing three-dimensional crosslinked product and the polymer compound containing a fluorine atom with a non-three-dimensional crosslinked structure in the release layer is preferably 5:95 to 50:50, more preferably 10:90 to 40:60, and still more preferably 15:85 to 30:70.

«Solvent»

In the case where the composition for forming a release agent layer of the present invention is formed into a layer form by application, it is preferable to blend the solvent. As the solvent, a known solvent can be used without limitation as long it can form a release layer.

As the solvent, any known solvent which can form a release layer can be used without limitation. The same solvents as those in the protective layer as described above can be used and perfluoroalkane can also be used. Among these, N-methyl-2-pyrrolidone, 2-butanone, methyl amyl ketone, Limonene, 1-methoxy-2-propylacetate (PGMEA), perfluoroalkane, methyl ethyl ketone, or the like can be used, with N-methyl-2-pyrrolidone, 2-butanone, methyl amyl ketone, Limonene, and 1-methoxy-2-propylacetate (PGMEA) being preferable.

From the viewpoints of improvement of the state of the coating surface, and the like, a form of mixing two or more kinds of the solvents is also preferable.

In the case where the composition for forming a release layer has a solvent, the solvent is preferably used such that the solid concentration of the composition for forming a release layer is preferably 3% by mass to 40% by mass, and more preferably 5% by mass to 40% by mass.

One kind or two or more kinds of the solvent may be used. In the case where two or more kinds of the solvent are used, the total sum thereof is preferably within the above range.

«Other Additives»

The composition for forming a release layer can further include various compounds depending on the purposes, within a range not interfering with the effects of the present invention. For example, a thermopolymerization initiator, a thickening dye, a chain transfer agent, an antioxidant, or a surfactant can be preferably used.

Specific examples and preferred examples of a surfactant which the composition for forming a release layer may have are the same as for the aforementioned surfactant that the composition for forming a protective layer may have.

Specific examples and preferred examples of an antioxidant which the composition for forming a release layer may have are the same as for the aforementioned antioxidant that the composition for forming a protective layer may have.

The release layer can be formed by coating the composition for forming a release layer, including the aforementioned respective components, by a spin coating method, a spraying method, a roller coating method, a flow coating method, a doctor coating method, a dipping method, or the like, which is known in the related art, followed by drying. Among these, the spin coating method, the spraying method, and the screen printing method are preferable, the spin coating and the spray method are more preferable, and the spin coating method is particularly preferable.

The release layer was adhered with a 300-mm wafer attached with a protective layer, and the maximum adhesive force during the peeling is preferably 20 N or less, more preferably 15 N or less, and still more preferably 10 N or less.

Moreover, the line peeling adhesive strength of the release layer is preferably 0.07 N/mm or less, more preferably 0.05 N/mm or less, and still more preferably 0.03 N/mm or less.

The average thickness of the release layer is preferably 1 nm to 20 μm, more preferably 1 nm to 10 μm, still more preferably 1 nm to 5 μm, and particularly preferably 1 nm to 1 μm.

The storage elastic modulus of the release layer at 25°C is preferably 1 M to 10 GPa, more preferably 10 M to 10 GPa, and still more preferably 100 M to 10 GPa. By curing the release layer, adhesion of the release layer to the protective layer can be prevented, which is thus preferable.

Furthermore, the ratio of the storage elastic modulus of the release layer to the storage elastic modulus of the protective layer is preferably 2:1 to 1,000:1, more preferably 5:1 to 1,000:1, and still more preferably 10:1 to 1,000:1.

<Support Substrate>

The laminate of the present invention includes a support substrate. The material for the support substrate is

not particularly limited, and examples thereof include a silicon substrate, a glass substrate, a metal substrate, a sapphire substrate, an SiC substrate, and a GaN substrate, with the silicon substrate being preferable from the viewpoints that it is difficult to contaminate the silicon substrate typically used as a substrate of a semiconductor device, an electrostatic chuck commonly used in a step of producing a semiconductor device can be used, and others.

The thickness of the support substrate is not particularly limited and is preferably 300 μm to 5 mm.

<Device Wafer>

The laminate of the present invention includes a device wafer. In the device wafer, the entire surface in contact with the protective layer is covered with the protective layer.

As the device wafer, known ones can be used without limitation, and examples thereof include MEMS and a device for a sensor.

The device wafer preferably has a structure ((for example, a metal bump), and the height of the structure is preferably 5 μm to 100 μm.

For the metal bump, solder or copper is preferably used, and copper is more preferably used.

The film thickness of the device wafer is preferably 500 μm or more, more preferably 600 μm or more, and still more preferably 700 μm or more.

As described in detail later, the device wafer preferably becomes thinner by subjecting the surface of a region in contact with the protective layer to a mechanic or chemical treatment for reducing the thickness such that the film thickness is less than 500 μm. A more preferable film thickness is 400 μm or less, and a still more preferable film thickness is 300 μm or less.

Kit:

The present invention relates to a kit which includes a composition for forming a protective layer, including a resin and a solvent, and a composition for forming a release layer, including a material containing a fluorine atom and/or a silicon atom and a solvent.

It becomes possible to manufacture the laminate of the present invention by coating a composition for forming a release layer on a support substrate and coating a composition for forming a protective layer after the composition for forming a protective layer.

Each of the composition, preferred range, and the like of the composition for forming a release layer and the composition for forming a protective layer is the same as described above in the sections of the composition for forming a release layer and the composition for forming a protective layer.

Method for Manufacturing Laminate:

The laminate of the present invention includes a release layer, a protective layer, and a device wafer in this order on a support substrate. The laminate of the present invention can be manufactured by a method for adhering a support substrate having a release layer and a protective layer to a device wafer, a method for adhering a support substrate having a release layer to a protective layer, or a method for adhering a support substrate to a device wafer having a release layer and a protective layer. From the viewpoints of adhesiveness and release peelability, a method for adhering a support substrate having a release layer and a protective layer to a device wafer, or a method for adhering a support substrate having a release layer to a protective layer is preferable, and a method for adhering a support substrate having a release layer to a device wafer having a protective layer is most preferable in order to prevent defects referred to a void in a laminate from being further generated.

Method for Producing Semiconductor Device:

Next, a method for preparing an adhesive support and a method for producing a semiconductor device, using the laminate in the present invention as described above will be described.

The method for producing a semiconductor device includes a step of adhering a first surface of a member to be treated to a substrate via the laminate of the present invention, a step of subjecting the member to be treated to a heating treatment with a maximum attainable temperature being in the range of 130°C to 370°C to obtain a treated member; and a step of dissociating the treated member from an adhesive layer laminate. In the present invention, it is possible to separate a device wafer from a support while not carrying out a treatment with a solvent.

The method for producing a semiconductor device includes a step of carrying out a heating treatment. The heating of carrying out a heating treatment is not particularly limited as long as it is a step of carrying out heating in the step of producing a semiconductor device, but for example, a step of heating a thinner silicon substrate which is supported

by an adhesive support is preferable, and a step of carrying out a heating treatment during the formation of a through-silicon electrode is more preferable.

The step of carrying out a heating treatment with a method for producing a semiconductor device in the present invention is a step of carrying out a heating treatment with a maximum attainable temperature being in the range of 130°C to 370°C, and a step of carrying out a heating treatment with a maximum attainable temperature being in the range of 180°C to 350°C is preferable.

Hereinafter, the method for producing a semiconductor of the present invention will be described in more detail.

Figs. 1A, 1B, and 1C in Fig. 1 are a schematic cross-sectional view showing the temporary adhesion between an adhesive support and a device wafer, a schematic cross-sectional view showing a device wafer temporarily adhered by an adhesive support, and a schematic cross-sectional view showing a state in which the device wafer temporarily adhered by an adhesive support becomes thinner, respectively.

As shown in Fig. 1A, in a device wafer 60 (member to be treated), a plurality of device chips 62 are provided on a surface 61a of a silicon substrate 61. Further, a protective layer 71 is further provided on a surface on the side of a structure 62 of the device wafer 60.

The device wafer 60 preferably has a film thickness with an average film thickness of 500 μm or more. Further, the structure 62 is referred to as a device chip or a bump and the average height is preferably in the range of 5 μm to 100 μm.

Moreover, as shown in Fig. 1A, an adhesive support 100 in which a release layer 11 is provided on a support substrate 12 is prepared.

The release layer 11 can be formed by applying the composition for forming a release layer onto a support substrate 12 by a spin coating method, a spraying method, a roller coating method, a flow coating method, a doctor coating method, or a dipping method, which has been known in the related art, followed by drying.

Next, the temporary adhesion of the support 100 thus obtained with the device wafer, the reduction in the thickness of the device wafer, and the dissociation of the device wafer from the support will be described in detail.

Furthermore, the surface of the protective layer 71 is pressed onto the release layer 11 of the adhesive support 100. Thus, as shown in Fig. 1B, a surface of the protective layer 71 is adhered to the release layer 11 to form a temporary bonding layer 80 having the protective layer 71 and the release layer 11.

Next, a back surface 61b of the silicon substrate 61 is subjected to a mechanical or chemical treatment, specifically, a treatment for reducing the thickness such as grinding and chemical mechanical polishing (CMP) to reduce the thickness (for example, an average thickness of less than 500 μm, and preferably 1 μm to 200 μm) of the silicon substrate 61, thereby obtaining a thin device wafer 60', as shown in Fig. 1C.

Furthermore, as the mechanical or chemical treatment, after the treatment for reducing the thickness, a treatment for forming a through hole (not shown) passing through the silicon substrate from the back surface 61b' of the thin device wafer 60' and forming a though-silicon electrode (not shown) in the through hole may be carried out after the treatment for reducing the thickness of the film. Specifically, the maximum attainable temperature in the heating treatment is preferably in the range of 130°C to 370°C, and preferably in the range of 180°C to 350°C. The maximum attainable temperature in the heating treatment is a temperature lower than the softening point of the protective layer. The heating treatment is preferably heating at a maximum attainable temperature for 30 seconds to 30 minutes, and more preferably heating at a maximum attainable temperature for 1 minute to 10 minutes.

Next, the surface 61a of the thin device wafer 60' is dissociated from the release layer 11 of the adhesive support 100.

The dissociation of the release layer is preferably carried out by a physical function such as peeling. That is, the release is preferably carried out by sliding the thin device wafer 60' to the adhesive support 100, or peeling the thin device wafer 60' from the adhesive support 100. By the method, the temporary adhesion of the release layer 11 to the surface 61a of the thin device wafer 60' can be easily released. Further, peeling may be carried out by using the peeling solution which will be described later.

The thin device wafer 60' is dissociated from the adhesive support 100, and then, if desired, the protective layer is removed. Examples of the method for removing the protective layer 71 include a method for peeling or removing the film shape as it is, a method for peeling or removing the layer by swelling an aqueous solution or an organic solvent, a method for breaking or removing the layer by spraying an aqueous solution or an organic solvent, a method for breaking or removing the layer by dissolving an aqueous solution or an organic solvent, a method for removing the layer by degradation or vaporization by irradiation with actinic rays, radiation, or heat, and a method for removing the layer by a combination of at least two of the aforementioned methods.

Among the removal methods, the method for peeling or removing the film shape as it is or the method for dissolving and removing the layer by dissolving an aqueous solution or an organic solvent can be preferably used.

As the aqueous solution or organic solvent, any solution which can dissolve and remove the protective layer can be arbitrarily used, and specifically, the following peeling solutions can be preferably used.

<Peeling Solution>

Hereinafter, the peeling solution will be described in detail.

As the peeling solution, water and a solvent (organic solvent) can be used. Examples of the organic solvent include an aliphatic hydrocarbon (hexane, heptane, Isopar E, H, and G (manufactured by Exxon Chemical Co., Ltd., and the like), an aromatic hydrocarbon (toluene, xylene, mesitylene, and the like), a halogenated hydrocarbon (methylene dichloride, ethylene dichloride, triclene, monochlorobenzene, and the like), and a polar solvent. Examples of the polar solvent include alcohols (methanol, ethanol, propanol, isopropanol, 1-butanol, 1-pentanol, 1-hexanol, 1-heptanol, 1-octanol, 2-octanol, 2-ethyl-1-hexanol, 1-nonanol, 1-decanol, benzyl alcohol, ethylene glycol monomethyl ether, 2-ethoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, decalinepropylene glycol monophenyl ether, methyl phenyl carbinol, n-amyl alcohol, methylamyl alcohol, and the like), ketones (acetone, methyl ethyl ketone, ethyl butyl ketone, methyl isobutyl ketone, cyclohexanone, and the like), esters (ethyl acetate, propyl acetate, butyl acetate, amyl acetate, benzyl acetate, methyl lactate, butyl lactate, ethylene glycol monobutyl acetate, decaline, propylene glycol monomethyl ether acetate, diethylene glycol acetate, diethyl phthalate, butyl levulinate, and the like), and others (triethyl phosphate, tricresyl phosphate, N-phenylethanolamine, N-phenyldiethanolamine, N-methyldiethanolamine, N-ethyldiethanolamine, 4-(2-hydroxyethyl)morpholine, N,N-dimethylacetamide, N-methylpyrrolidone, and the like).

Further, from the viewpoint of peelability, the peeling solution may include an alkali, an acid, and a surfactant. In the case of blending these components, the blending amounts are each preferably 0.1% by mass to 5.0% by mass with respect to the peeling solution.

In addition, from the viewpoint of the peelability, an embodiment of mixing two or more kinds of the organic solvents and water or an embodiment of mixing two or more kinds the alkalis, acids and surfactants is also preferable.

As the alkali, an inorganic alkali agent such as, for example, sodium tertiary phosphate, potassium tertiary phosphate, ammonium tertiary phosphate, sodium secondary phosphate, potassium secondary phosphate, ammonium secondary phosphate, sodium carbonate, potassium carbonate, ammonium carbonate, sodium hydrogen carbonate, potassium hydrogen carbonate, ammonium hydrogen carbonate, sodium borate, potassium borate, ammonium borate, sodium hydroxide, ammonium hydroxide, potassium hydroxide, and lithium hydroxide, or an organic alkali agent such as, for example, monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine, and tetramethylammonium hydroxide can be used. The alkali agents can be used singly or in combination of two or more kinds thereof.

As the acid, an inorganic acid such as hydrogen halide, sulfuric acid, nitric acid, phosphoric acid, and boric acid, or an organic acid such as methanesulfonic acid, ethanesulfonic acid, benzenesulfonic acid, p-toluenesulfonic acid trifluoromethanesulfonic acid, acetic acid, citric acid, formic acid, gluconic acid, lactic acid, oxalic acid, and tartaric acid can be used.

As the surfactant, an anionic, cationic, nonionic or amphoteric surfactant can be used. In this case, the content of the surfactant is preferably 1% by mass to 20% by mass, and more preferably 1% by mass to 10% by mass, with respect to the total amount of the aqueous alkali solution.

By controlling the content of the surfactant to the above range, the peelability of the thin device wafer 60' from the adhesive support 100' tends to be further improved.

The anionic surfactant is not particularly limited and examples thereof include fatty acid salts, abietates, hydroxyalkane sulfonates, alkane sulfonates, dialkylsulfosuccinates, linear alkylbenzene sulfonates, branched alkylbenzene sulfonates, alkylnaphthalene sulfonates, alkyldiphenyl ether disulfonates, alkylphenoxy polyoxyethylene alkylsulfonates, polyoxyethylene alkylsulfophenyl ether salts, N-alkyl-N-oleyltaurine sodium salts, N-alkylsulfosuccinic acid monoamide disodium salts, petroleum sulfonates, sulfated castor oil, sulfated beef tallow oil, sulfate ester salts of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styryl phenyl ether sulfate ester salts, alkyl phosphate ester salts, polyoxyethylene alkyl ether phosphate ester salts, polyoxyethylene alkyl phenyl ether phosphate ester salts, partially saponified products of styrene-maleic anhydride copolymers, partially saponified products of olefin-maleic anhydride copolymers, and naphthalene sulfonate formalin condensates. Among these, alkylbenzene sulfonates, alkylnaphthalene sulfonates, and alkyldiphenyl ether disulfonates are particularly preferably used.

The cationic surfactant is not particularly limited and cationic surfactants known in the related art can be used. Examples of the cationic surfactant include alkylamine salts, quaternary ammonium salts, alkylimidazolinium salts, polyoxyethylene alkyl amine salts, and polyethylene polyamine derivatives.

The nonionic surfactant is not particularly limited and examples thereof include polyethylene glycol type higher alcohol ethylene oxide adducts, alkylphenol ethylene oxide adducts, alkylnaphthol ethylene oxide adducts, phenol ethylene oxide adducts, naphthol ethylene oxide adducts, fatty acid ethylene oxide adducts, polyhydric alcohol fatty acid ester ethylene oxide adducts, higher alkylamine ethylene oxide adducts, fatty acid amide ethylene oxide adducts, ethylene oxide adducts of fat, polypropylene glycol ethylene oxide adducts, dimethylsiloxane-ethylene oxide block copolymers, dimethylsiloxane-(propylene oxide-ethylene oxide) block copolymers, fatty acid esters of polyhydric alcohol type glycerol, fatty acid esters of pentaerythritol, fatty acid esters of sorbitol and sorbitan, fatty acid esters of sucrose, alkyl ethers of polyhydric alcohols and fatty acid amides of alkanolamines. Among these, those having an aromatic ring and an ethylene oxide chain are preferable, and alkyl-substituted or unsubstituted phenol ethylene oxide adducts and alkyl-substituted or unsubstituted naphthol ethylene oxide adducts are more preferable.

The amphoteric surfactant is not particularly limited and examples thereof include amine oxides such as alkyldimethylamine oxide, betaines such as alkyl betaine, and amino acids such as sodium salts of alkylamino fatty acids. In particular, alkyldimethylamine oxide which may have a substituent, alkyl carboxyl betaine which may have a substituent, and alkyl sulfo betaine which may have a substituent are preferably used. Specifically, the compounds represented by Formula (2) described in paragraph No. "0256" of JP2008-203359A, the compounds represented by Formulae (I), (II), and (VI) described in paragraph No. "0028" of JP2008-276166A, and the compounds described in paragraph Nos. "0022" to "0029" of JP2009-47927A can be used.

The peeling solution can also contain an additive such as a defoaming agent and a water softener, if desired.

The thin device wafer 60' is subjected to various known treatments to produce a semiconductor device having the thin device wafer 60'.

In the present invention, the adhering method is not particularly limited as long as it includes a configuration of a device wafer, a protective layer, a release layer, and a support in this order, in which the protective layer is in contact only with the device wafer and the release layer is in contact only with the protective layer and the support. A laminate having a release layer and a protective layer provided on a support may be manufactured in advance and a device wafer may be bonded onto the protective layer which is the uppermost part of the laminate.

In the present invention, from the viewpoint of protecting the surface of the device wafer, it is preferable that the protective layer covers the entire surface of the device wafer.

Next, an embodiment in the related art will be described.

Fig. 2 is a schematic cross-sectional view illustrating the release of a temporary adhering state between an adhesive support and a device wafer in the related art.

In the embodiment in the related art, as shown in Fig. 2, except for using as the adhesive support, an adhesive support 100' having a release layer 11' formed from a temporary adhesive in the related art provided on a support substrate 12, the temporary adhesion of the adhesive support 100' to a device wafer and the treatment for reducing the thickness of the silicon substrate in the device wafer are carried out by the same procedures as described with reference to Figs. 1A and 1B, and then a thin device wafer 60' having the silicon substrate 61 is peeled from the adhesive support 100' by the same procedure as described above.

However, according to the temporary adhesive in the related art, it is difficult to temporarily support a member to be treated with a strongly adhesive force and to easily release the temporary support for the member processed while not damaging the member processed. For example, when a temporary adhesive having a high adhesiveness out of the temporary adhesives in the related art is adopted in order to perform sufficiently temporary adhesion between a device wafer and a carrier substrate, the temporary adhesion between the device wafer and the carrier substrate tends to become too strong. Thus, for example, in the case where a tape (for example, a dicing tape) 70 is adhered on a back surface 61b' of a thin device wafer 60' and the thin device wafer 60' is peeled from the adhesive support 100' for the purpose of releasing such a strong temporary adhesion, as shown in Fig. 2, problems in that a structure 63 having a device chip 62 is dissociated or the structure 63 is damaged easily occur.

On the other hand, when a temporary adhesive having a low adhesiveness out of the temporary adhesives in the related art is adopted, the temporary adhesion between a device wafer and a carrier substrate is too weak and thus, has a problem in that the device wafer cannot be firmly supported by the carrier substrate.

However, the release layer and the protective layer, thus formed by the laminate of the present invention, can exhibit sufficient adhesiveness while providing easy release. That is, by the laminate in the present invention, the device wafer 60 can be reliably and easily provided with a temporary support with a strongly adhesive force and the temporary support for the thin device wafer 60' can be easily released while not damaging the thin device wafer 60'.

The method for forming a laminate and the method for producing a semiconductor device of the present invention are not limited to the embodiments as described above, and appropriate modifications, improvements, and the like can be made therein.

In addition, in the embodiments as described above, the release layer has a single-layer structure, but the release layer may have a multilayer structure.

In the embodiments as described above, as the member to be treated which is supported by the adhesive support, a silicon substrate is exemplified, but the member to be treated is not limited thereto and may be any member to be treated which may be subjected to a mechanical or chemical treatment in the method for producing a semiconductor

device.

For example, examples of the member to be treated include a compound semiconductor substrate, and specific examples of the compound semiconductor substrate include an SiC substrate, an SiGe substrate, a ZnS substrate, a ZnSe substrate, a GaAs substrate, an InP substrate, and a GaN substrate.

Moreover, in the embodiments as described above, as the mechanical or chemical treatment coated on the silicon substrate which is supported by the adhesive support, a treatment for reducing the thickness of the silicon substrate or a treatment for forming a through-silicon electrode is exemplified, but the treatment is not limited thereto and may be any treatment required in the method for producing a semiconductor device.

The shape, the dimension, the number, the arrangement positions, and the like of the device chip in the device wafer are arbitrary and not limited as long as the present invention can be achieved.

## EXAMPLES

The present invention will be described more specifically with reference to Examples, but the present invention is not limited thereto as long as the gist of the present invention is not deviated. Here, "part(s)" and "%" are on the basis of mass unless otherwise specified.

<Formation of Release Layer-Support Substrate (Formation of Wafer 1)>

Each of compositions for forming a release layer having the compositions shown in the following table was coated on a 4-inch Si wafer by a spin coater (Opticoat MS-A100, manufactured by Mikasa Co., Ltd., 1,200 rpm, 30 seconds) and then baked at 120°C for 30 seconds and at 190°C for 3 minutes to form a wafer 1 having a release layer having a thickness of 0.10 μm provided thereon.

[Table 1]

| Composition for forming release layer | Compound containing fluorine and/or silicon atom (5 parts by weight) | Solvent (95 parts by weight) |
|---|---|---|
| Composition 1 for forming a release layer | A-1 | Perfluorohexane |
| Composition 2 for forming a release laver | A-2 | PGMEA |
| Composition 3 for forming a release layer | A-3 | PGMEA |
| Composition 4 for forming a release layer | A-4 | PGMEA |
| Composition 5 for forming a release layer | A-5 | Perfluorohexane |
| Composition 6 for forming a release layer | A-6 | PGMEA |
| Composition 7 for forming a release layer | A-7 | Perfluorohexane |
| Composition 8 for forming a release layer | A-8 | CT-Solv 180 (manufactured by AGC Chemicals Europe Ltd.) |
| Composition 9 for forming a release layer | A-9 | PGMEA |
| Composition 10 for forming a release layer | A-10 | MEK |
| Composition 11 for forming a release layer | A-11 | PGMEA/mesitylene 1/1 (weight ratio) |

The compounds described in Table 1 are as follows.

[Compounds Containing Fluorine Atom and/or Silicon Atom]

A-1: OPTOOL DSX (manufactured by Daikin Industries, Ltd., fluorine-based compound)
A-2: RS-72-K (manufactured by DIC Corporation, fluorine-based compound)
A-3: RS-76-E (manufactured by DIC Corporation, fluorine-based compound)
A-4: UV-3500B (manufactured by BYK-Chemie, silicon-based compound)
A-5: (heptadecafluoro-1,1,2,2-tetrahydrodecyl)trichlorosilane (manufactured by TCI)
A-6: CHEMINOX FHP-2-OH (manufactured by Unimatec Co., Ltd., fluorine-based compound)
A-7: TEFLON (registered trademark) AF (manufactured by Mitsui-Dupont Fluoro Chemicals Co., Ltd., fluorine-based compound)
A-8: CYTOP (manufactured by Asahi Glass Co., Ltd., fluorine-based compound)
A-9: KP541 (manufactured by Shin-Etsu Chemical Co., Ltd., silicon-based compound)
A-10: Dyneon THV (manufactured by 3M, fluorine-based compound)
A-11: A mixture of RS-72-K and DAIFREE FB962 (manufactured by Daikin Industries, Ltd., fluorine-based compound) at 15:85 (weight ratio).

Among those, the compounds in which the release layer constitute the three-dimensional crosslinked structure are A-1 to A-4, and A-11.

[Solvent]

Perfluorohexane: (manufactured by Wako Pure Chemical Industries, Ltd.)
CT-Solv 180: AGC Chemicals Europe Ltd.
Mesitylene
Decalinee
PGMEA: 1-Methoxy-2-propylacetate
MEK: Methylethylketone
NEP: N-Methyl-2-pyrrolidone

<Formation of Protective Layer-Device Wafer (Formation of Wafer 2)>

Each of compositions for forming a protective layer having the compositions shown in the following table was coated on the side having an electrode of a 4-inch Si wafer present thereon, in which Cu electrodes having a height of 10 μm and a diameter of 50 μm are formed on the surface at an interval of 200 μm, by a spin coater (Opticoat MS-A100, produced by Mikasa Co., Ltd., 1,200 rpm, 30 seconds) and then baked on a hot plate at 80°C for 10 minutes and at 250°C for 15 minutes to form a film.

The softening point was measured by means of a viscoelasticity measuring apparatus Rheosol-G5000 (manufactured by UBM Co., Ltd.). Specifically, the softening point of the protective layer is measured as a temperature at which the loss tangent (tanδ) measured using an viscoelastiity measuring apparatus under a constant temperature rising condition becomes a maximum. In Examples, the softening point was measured by means of a viscoelasticity measuring apparatus Rheosol-G5000 by raising the temperature of the protective layer from 25°C to 500°C at a temperature rising rate of 5°C/min and setting a modification at a modification angle of 0.05 degrees with respect to the protective layer at a cycle of 1 Hz.

[Table 2]

| Composition for forming protective layer | Resin (20 parts by weight) | Solvent (80 parts by weight) | Protective layer softening point (°C) |
|---|---|---|---|
| Composition 1 for forming protective layer | B-1 | Anisole | 222 |

(continued)

| Composition for forming protective layer | Resin (20 parts by weight) | Solvent (80 parts by weight) | Protective layer softening point (°C) |
|---|---|---|---|
| Composition 2 for forming protective layer | B-2 | PGMEA | 60 |
| Composition 3 for forming protective laver | B-3 | PGMEA | 100 |
| Composition 4 for forming protective layer | B-4 | Limonene | 120 |
| Composition 5 for forming protective layer | B-5 | Limonene | 50 |
| Composition 6 for forming protective layer | B-6 | Limonene | 120 |
| Composition 7 for forming protective layer | B-7 | Mesitylene | 75 |
| Composition 8 for forming protective layer | B-8 | Mesitylene | 75 |
| Composition 9 for forming protective layer | B-9 | MEK | 200 |
| Composition 10 for forming protective layer | B-10 | PGMEA | 50 |
| Composition 11 for forming protective layer | B-11 | NEP | 225 |
| Composition 12 for forming protective layer | B-12 | NEP | 350 |

(continued)

| Composition for forming protective layer | Resin (20 parts by weight) | Solvent (80 parts by weight) | Protective layer softening point (°C) |
|---|---|---|---|
| Composition 13 for forming protective layer | B-13 | Mesitylene | 80 |
| Composition 14 for forming protective layer | B-14 | Mesitylene | 110 |
| Composition 15 for forming protective layer | Formed by adding 5 parts by weight of TOTM (manufactured by TCI) to the composition 1 for forming protective layer | | 120 |
| Composition 16 for forming protective layer | Formed by adding 2 parts by weight of Irganox 1010 (manufactured by BASF) to the composition 13 for forming protective layer | | 80 |
| Composition 17 for forming protective layer | Formed by adding 1 part by weight of Irganox 1010 (manufactured by BASF) and 1 part by weight of Sumilizer TP-D (manufactured by Sumitomo Chemical Co., Ltd.) to the composition 13 for forming protective layer | | 80 |
| Composition 18 for forming protective layer | B-15 | Mesitylene | 75 |
| Composition 19 for forming protective layer | B-16 | Mesitylene | 80 |
| Composition 20 for forming protective layer | B-17 | Mesitylene | 90 |
| Composition 21 for forming protective layer | B-18 | Mesitylene | 100 |
| Composition 22 for forming protective layer | B-4 | Mesitylene | 120 |
| Composition 23 for forming protective layer | Formed by adding 1 part by weight of Irganox 1010 (manufactured by BASF), 1 part by weight of Sumilizer TP-D (manufactured by Sumitomo Chemical Co., Ltd.), and 2 parts by weight of decaline to the composition 19 for forming a protective layer | | 80 |

(continued)

| Composition for forming protective layer | Resin (20 parts by weight) | Solvent (80 parts by weight) | Protective layer softening point (°C) |
|---|---|---|---|
| Composition 24 for forming protective layer | Formed by adding 1 part by weight of Irganox 1010 (manufactured by BASF) and 1 part by weight of Sumilizer TP-D (manufactured by Sumitomo Chemical Co., Ltd.) to the composition 20 for forming protective layer | 90 | |
| Composition 25 for forming protective layer | Formed by adding 1 part by weight of Irganox 1010 (manufactured by BASF) and 1 part by weight of Sumilizer TP-D (manufactured by Sumitomo Chemical Co., Ltd.) to the composition 21 for forming protective layer | 100 | |
| Composition 26 for forming protective layer | Formed by adding 1 part by weight of Irganox 1010 (manufactured by BASF) and 1 part by weight of Sumilizer TP-D (manufactured by Sumitomo Chemical Co., Ltd.) to the composition 22 for forming protective layer | 120 | |

The compounds described in Table 2 are as follows.

[Resins]

B-1: APEC9379 (manufactured by BAYER Inc.)

B-2: polystyrene (manufactured by ALDRICH, Mw=100,000)

B-3: ESTYRENE MS200NT (manufactured by Nippon Steel Chemical Co., Ltd.)

B-4: SEPTON S2104 (manufactured by Kuraray Co., Ltd.)

B-5: SEPTON S2063 (manufactured by Kuraray Co., Ltd.)

B-6: SEPTON S8104 (manufactured by Kuraray Co., Ltd.)

B-7: TOPAS8007 (manufactured by Polyplastics Co., Ltd.)

B-8: APEL8008 (manufactured by Mitsui Chemicals, Inc.)

B-9: L-70 (manufactured by Daicel Chemical Industries, Ltd., cellulose acetate)

B-10: Buna EP T6250 (manufactured by LANXESS Corporation)

B-11: Ultrason E2020 (manufactured by BASF)

B-12: Durimide 284 (manufactured by FUJIFILM Electronics Materials Co., Ltd)

B-13: TUFTEC P2000 (manufactured by Asahi Kasei Chemicals Corp.)

B-14: TUFTEC H1043 (manufactured by Asahi Kasei Chemicals Corp.)

B-15: A mixture of TUFTEC P2000 (manufactured by Asahi Kasei Chemicals Corp.), and DAIFREE FB962 (manufactured by Daikin Industries, Ltd., fluorine-based compound) at 4:1 (weight ratio).

B-16: SEPTON S2002 (manufactured by Kuraray Co., Ltd.)

B-17: SEPTON S2004 (manufactured by Kuraray Co., Ltd.)

B-18: SEPTON S2007 (manufactured by Kuraray Co., Ltd.)

<Manufacture of Wafer of Comparative Examples>

<<Comparative Example 1>>

The same procedure as in Example 1 except that a release layer was not formed was carried out.

«Comparative Example 2»

The same procedure as in Example 1 except that a protective layer was not formed was carried out.

«Comparative Example 3»

The same procedure as in Example 1 except that a protective layer was formed on a support substrate and a release layer was formed on a device wafer was carried out.

<<Comparative Example 4»

The same procedure as in Example 1 except that a release layer was not formed and a protective layer composition 10 was used as the composition for forming a protective layer was carried out.

<Manufacture of Test Piece>

The wafer 1 and the wafer 2 were thermally compressed by a combination described in the following table to manufacture a test piece.

[Compression]

A 4-inch Si wafer having nothing applied on the surface thereof or the wafer 2, was split to obtain a sample piece at 20 mm x 30 mm. A release layer of a sample piece of the wafer 1 at 20 mm x 30 mm, which has been split in the same manner was in contact with a protective layer of a wafer having nothing applied on the surface thereof or the wafer 2 in a rectangular shape at 20 mm x 20 mm, and pressed and adhered at 190°C and 0.11 MPa for 5 minutes.

[Baking]

After pressing and adhering, the sample piece was heated to the temperature described in the following table.

<Evaluation of Adhesiveness of Laminate Test Piece>

The shear adhesive force of the test piece manufactured above was subjected to a tensile measurement under the condition of 50 mm/min in the direction along the surface of the release layer, using a tensile tester (manufactured by Imada Ltd.), and evaluated by the following criteria.

A: Adhesive force of 10 N or more
B: Adhesive force of less than 10 N

<Evaluation of Peelability of Laminate Test piece>

The manufactured sample piece was subjected to a tensile measurement in the direction perpendicular to the surface of the release layer under the condition of 50 mm/min, and evaluated by the following criteria.

A: Peelable with a force of 6 N or less
B: Peelable with a force of more than 6 N

C: The wafer is damaged in the process of peeling

<Evaluation of Cleaning Properties of Laminate Test Piece>

The manufactured sample piece was peeled and then the wafer on the device side was immersed in a solvent for each composition for forming a protective layer, and the time taken until both of the release layer and the protective layer were removed from the wafer 2 was measured and evaluated by the following criteria.

AA: The layers were removed within 2 minutes and the floating of gel-type materials in the removal liquid was not observed
A: The layers were removed within 2 minutes and the floating of gel-type materials in the removal liquid was observed
B: Irrespective of gel-type materials, the layer was removed in more than 2 minutes and 5 minutes or less
C: Irrespective of gel-type materials, the layer was removed in more than 5 minutes and 10 minutes or less
D: Irrespective of gel-type materials, the layer was not removed within 10 minutes

<Evaluation of Adhesion Flatness of Laminate Test piece>

The manufactured sample piece was peeled and then the TTV (a sum of the maximal value of the film thickness and the minimal value of the film thickness) of the peeled side of the wafer on the device side was measured and evaluated by the following criteria.

A: TTV is 0.5 μm or less

B: TTV is more than 0.5 μm and 1 μm or less

C: TTV is more than 1 μm and 2 μm or less

D: TTV is more than 2 μm

[Table 3]

| | Release layer | Protective layer | Adhesiveness | Peelability | Cleaning Properties | Adhesion flatness |
|---|---|---|---|---|---|---|
| Comparative Example 1 | No release laver | Protective layer composition 1 | A | C | - | C |
| Comparative Example 2 | Release layer composition 1 | No protective laver | B | - | - | Not adhered |
| Comparative Example 3 | Protective layer composition 1 | Release layer composition 1 | A | C (bump damaged) | D | Not measureable due to breakage |
| Comparative Example 4 | No release layer | Protective layer composition 10 | A | C | B | C |
| Example 1 | Release layer composition 1 | Protective layer composition 1 | A | A | B | C |
| Example 2 | Release layer composition 2 | Protective layer composition 1 | A | A | B | C |

(continued)

| | Release layer | Protective layer | Adhesiveness | Peelability | Cleaning Properties | Adhesion flatness |
|---|---|---|---|---|---|---|
| Example 3 | Release layer composition 3 | Protective layer composition 1 | A | A | B | C |
| Example 4 | Release layer composition 4 | Protective layer composition 1 | A | A | B | C |
| Example 5 | Release layer composition 5 | Protective layer composition 1 | A | B | C | C |
| Example 6 | Release layer composition 6 | Protective layer composition 1 | A | B | C | C |
| Example 7 | Release layer composition 7 | Protective layer composition 1 | A | B | C | C |
| Example 8 | Release layer composition 8 | Protective layer composition 1 | A | B | C | C |
| Example 9 | Release layer composition 9 | Protective layer composition 1 | A | B | C | C |
| Example 10 | Release layer composition 10 | Protective layer composition 1 | A | B | C | C |
| Example 11 | Release layer composition 1 | Protective layer composition 2 | A | A | A | A |
| Example 12 | Release layer composition 1 | Protective layer composition 3 | A | A | A | A |
| Example 13 | Release layer composition 1 | Protective layer composition 4 | A | A | A | A |
| Example 14 | Release layer composition 1 | Protective layer composition 5 | A | A | A | A |

(continued)

| | Release layer | Protective layer | Adhesiveness | Peelability | Cleaning Properties | Adhesion flatness |
|---|---|---|---|---|---|---|
| Example 15 | Release layer composition 1 | Protective layer composition 6 | A | A | A | A |
| Example 16 | Release layer composition 1 | Protective layer composition 7 | A | A | B | A |
| Example 17 | Release layer composition 1 | Protective layer composition 8 | A | A | B | A |
| Example 18 | Release layer composition 1 | Protective layer composition 9 | A | A | B | B |
| Example 19 | Release layer composition 1 | Protective layer composition 10 | A | A | B | A |
| Example 20 | Release layer composition 1 | Protective layer composition 11 | A | A | B | C |
| Example 21 | Release layer composition 1 | Protective layer composition 12 | A | A | B | D |
| Example 22 | Release layer composition 11 | Protective layer composition 1 | A | A | B | C |
| Example 23 | Release layer composition 11 | Protective layer composition 13 | A | A | A | A |
| Example 24 | Release layer composition 11 | Protective layer composition 14 | A | A | A | A |
| Example 25 | Release layer composition 11 | Protective layer composition 15 | A | A | A | A |
| Example 26 | Release layer composition 11 | Protective layer composition 16 | A | A | AA | A |

(continued)

| | Release layer | Protective layer | Adhesiveness | Peelability | Cleaning Properties | Adhesion flatness |
|---|---|---|---|---|---|---|
| Example 27 | Release layer composition 11 | Protective layer composition 17 | A | A | AA | A |
| Example 28 | Release layer composition 11 | Protective layer composition 18 | A | A | A | A |
| Example 29 | Release layer composition 11 | Protective layer composition 19 | A | A | A | A |
| Example 30 | Release layer composition 11 | Protective layer composition 20 | A | A | A | A |
| Example 31 | Release layer composition 11 | Protective layer composition 21 | A | A | A | A |
| Example 32 | Release layer composition 11 | Protective layer composition 22 | A | A | A | A |
| Example 33 | Release layer composition 11 | Protective layer composition 23 | A | A | AA | A |
| Example 34 | Release layer composition 11 | Protective layer composition 24 | A | A | AA | A |
| Example 35 | Release layer composition 11 | Protective layer composition 25 | A | A | AA | A |
| Example 36 | Release layer composition 11 | Protective layer composition 26 | A | A | AA | A |

It could be seen that in Comparative Example 1 in which the release layer was not used, the adhesiveness is obtained, but the peelability is insufficient. In Comparative Example 2 in which the protective layer was not used, the adhesiveness is insufficient, and in Comparative Example 3 in which the protective layer and the release layer were used, the adhesiveness is obtained by providing the release layer in the device wafer and providing the protective layer in the support substrate, the peelability is insufficient, and the structure (bump) was damaged during the peeling. In contrast, it could be seen that in the laminate of the present invention in Examples 1 to 28, both of the adhesiveness and the peelability can be satisfied, and also, the cleaning properties and the adhesion flatness are excellent.

In Examples 1 to 4 and 11 to 28, it could be seen that the release layer has improved peelability due to the

three-dimensional crosslinked product.

In Examples 1 to 4 and 11 to 28, it could be seen that the cleaning properties is further improved from the viewpoint of the elastic modulus of the release layer is higher than that of the protective layer and the release layer is not attached to the protective layer during the peeling.

Furthermore, in Examples 16 to 28, it could be seen that the adhesion flatness is further improved by setting the softening point of the protective layer to 200°C or lower.

In addition, in Example 25, the flatness is further improved by incorporating a plasticizer, and in Examples 26 and 27, the removability is further improved by the antioxidant.

Moreover, the sample pieces manufactured in Examples 1, 13 to 15, 21, 25 to 36 were peeled and a dicing tape (DU-300 manufactured by Nitto Denko Corporation) was then attached to the protective layer of the wafer on the device side. The side opposite to the side having the protective layer of the wafer applied thereon was fixed to a vacuum chuck and an end of the dicing tape was then pulled up to peel it from the wafer together with the protective layer. At this time, the protective layer manufactured in any of Examples could be peeled and removed from the wafer.

Explanation of References

11, 21 to 30, and 11' Release layers
11A, 21A to 30A Strongly adhesive regions
11B, 21B to 30B Weakly adhesive regions
12 Support substrate
60 Device wafer
60' Thin device wafer
61 Silicon substrate
61a Surface of silicon substrate
61b Back surface of silicon substrate
61b' Back surface of thin device wafer
62 Device chip
63 Structure
71 Protective layer
80 Temporary bonding layer
100, 100' Adhesive supports

## Claims

1. A laminate comprising:

   a device wafer;
   a protective layer;
   a release layer; and
   a support substrate in this order,
   wherein the protective layer is in contact only with the device wafer and the release layer, the release layer is in contact only with the protective layer and the support substrate, and the release layer contains a fluorine atom and/or a silicon atom.

2. The laminate according to claim 1, wherein the release layer has a three-dimensional crosslinked product containing a fluorine atom and/or a silicon atom.

3. The laminate according to claim 1, wherein the release layer includes a three-dimensional crosslinked product and 50% by mass or more of the three-dimensional crosslinked product is constituted with fluorine atoms.

4. The laminate according to any one of claims 1 to 3, wherein the release layer includes at least one of a radical polymerization product of a bifunctional or higher functional radically polymerizable monomer or oligomer containing a fluorine atom and a condensate of an alkoxysilane compound containing a fluorine atom.

5. The laminate according to any one of claims 1 to 4, wherein the protective layer includes a thermoplastic resin.

6. The laminate according to claim 5, wherein the thermoplastic resin includes at least one of a polycarbonate resin, a polystyrene resin, and a polystyrene copolymerized resin.

7. The laminate according to any one of claims 1 to 6, wherein the softening point of the protective layer is 200°C or lower.

8. The laminate according to any one of claims 1 to 7, wherein the protective layer further includes a plasticizer.

9. The laminate according to any one of claims 1 to 8, wherein the protective layer further includes an antioxidant.

10. The laminate according to any one of claims 1 to 9, wherein at least one of the release layer and the protective layer further includes a polymer compound containing a fluorine atom with a non-three-dimensional crosslinked structure.

11. The laminate according to any one of claims 1 to 10, wherein the average thickness of the device wafer is 500 μm or more.

12. The laminate according to any one of claims 1 to 10, wherein the average thickness of the device wafer is less than 500 μm.

13. The laminate according to any one of claims 1 to 12, wherein the device wafer has a structure having a height of 5 μm to 100 μm and the average thickness of the protective layer is more than the height of the structure.

14. A composition for forming a protective layer, used for forming the protective layer of the laminate according to any one of claims 1 to 13, comprising a solvent and a resin.

15. The composition for forming a protective layer according to claim 14, wherein the resin comprises a thermoplastic resin.

16. The composition for forming a protective layer according to claim 15, wherein the thermoplastic resin includes at least one of a polycarbonate, a polystyrene resin, and a polystyrene-copolymerized resin.

17. The composition for forming a protective layer according to any one of claims 14 to 16, wherein the softening point of the resin is 200°C or lower.

18. A composition for forming a release layer, used for forming the release layer of the laminate according to any one of claims 1 to 13, which comprises a material containing a fluorine atom and/or a silicon atom, and a solvent.

19. The composition for forming a release layer according to claim 18, wherein the material containing a fluorine atom and/or a silicon atom includes at least one of a bifunctional or higher functional radically polymerizable monomer or oligomer containing a fluorine atom, and an alkoxysilane compound containing a fluorine atom.

20. A kit for forming the laminate according to any one of claims 1 to 13, comprising a composition for forming a protective layer including a solvent and a resin, and a composition for forming a release layer, including a material containing a fluorine atom and/or a silicon atom and a solvent.

FIG. 1A

FIG. 1B

FIG. 1C

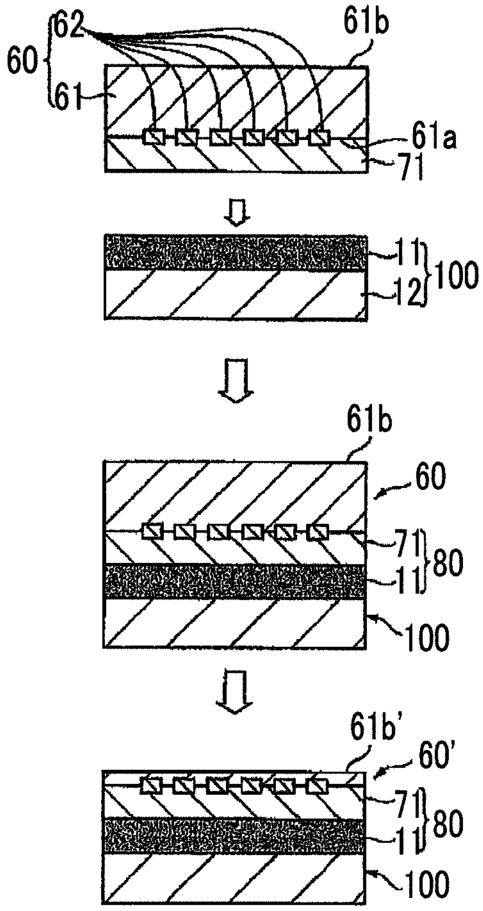

FIG. 2

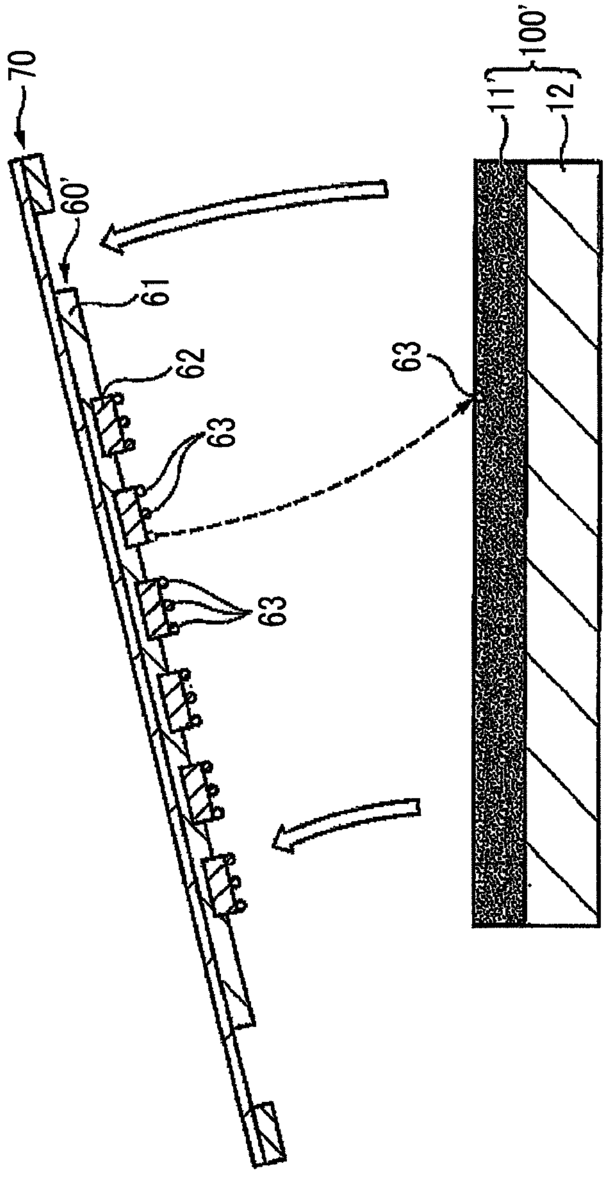

**INTERNATIONAL SEARCH REPORT**

International application No. PCT/JP2014/072370

A. CLASSIFICATION OF SUBJECT MATTER
*H01L21/02*(2006.01)i, *B24B37/30*(2012.01)i, *B32B27/00*(2006.01)i, *B32B27/30*(2006.01)i, *H01L21/304*(2006.01)i

According to International Patent Classification (IPC) or to both national classification and IPC

B. FIELDS SEARCHED

Minimum documentation searched (classification system followed by classification symbols)
H01L21/02, B24B37/30, B32B27/00, B32B27/30, H01L21/304

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2014 |
| Kokai Jitsuyo Shinan Koho | 1971-2014 | Toroku Jitsuyo Shinan Koho | 1994-2014 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y<br><br>A | JP 2012-64710 A (Asahi Glass Co., Ltd.),<br>29 March 2012 (29.03.2012),<br>paragraphs [0014] to [0067]; fig. 1 to 10<br>& US 2012/0064669 A1 & EP 2432010 A1<br>& KR 10-2012-0028847 A & CN 102403221 A<br>& TW 201214546 A1 | 1,2,5-7,<br>11-18,20<br>3,4,8-10,19 |
| Y<br><br>A | JP 2012-524399 A (Suss Microtec Lithography, GmbH),<br>11 October 2012 (11.10.2012),<br>paragraph [0028]; fig. 1A<br>& WO 2010/121068 A2 & US 2010/0263794 A1<br>& EP 2419928 A2 & KR 10-2012-0027237 A<br>& CN 102460677 A | 1,2,5-7,<br>11-18,20<br>3,4,8-10,19 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 30 October, 2014 (30.10.14) | 11 November, 2014 (11.11.14) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2014/072370

C (Continuation). DOCUMENTS CONSIDERED TO BE RELEVANT

| Category* | Citation of document, with indication, where appropriate, of the relevant passages | Relevant to claim No. |
|---|---|---|
| Y<br>A | JP 9-190955 A (Nitto Denko Corp.), 22 July 1997 (22.07.1997), paragraphs [0001], [0002], [0022] & US 5962097 A | 5-7,15-17<br>3,4,8-10,19 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2011119427 A
- JP 2009528688 A
- JP 2011225814 A
- JP 2011052142 A
- JP 2010506406 A
- JP 2007045939 A
- US 20110318938 A
- JP 2011510518 A
- JP 2011048358 A
- JP 2008203359 A
- JP 2008276166 A
- JP 2009047927 A